# EUROPEAN PATENT APPLICATION

(11) **EP 4 068 339 A2**
(43) Date of publication of application: **05.10.2022**
(21) Application number: 22165147.4
(22) Date of filing: 29.03.2022
(51) Int. Cl.: H01L 21/368

(54) **METAL OXIDE COMPOSITION, METHOD OF MANUFACTURING LIGHT-EMITTING DEVICE USING METAL OXIDE COMPOSITION, AND LIGHT-EMITTING DEVICE**

(30) Priority: 29.03.2021 KR 20210040506
(71) Applicant: Samsung Display Co., Ltd., Yongin-si, Gyeonggi-do 17113 (KR)
(72) Inventor: KIM, Sehun, 17113 Yongin-si (KR); LEE, Changhee, 17113 Yongin-si (KR); NOH, Seunguk, 17113 Yongin-si (KR); KANG, Jingoo, 17113 Yongin-si (KR); KIM, Yonghwi, 17113 Yongin-si (KR); KIM, Jonghoon, 17113 Yongin-si (KR); DOH, Hyunmi, 17113 Yongin-si (KR); PARK, Myoungjin, 17113 Yongin-si (KR); JUNG, Yunku, 17113 Yongin-si (KR)
(74) Representative: Marks & Clerk LLP

(57) **Abstract**

A metal oxide composition includes: a solvent; a metal oxide; and a hydrogen cation source including a compound of Formula 1, a compound of Formula 2, or any combination thereof: 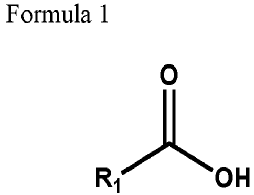 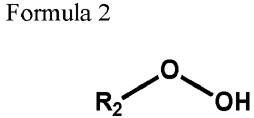 wherein, in Formulae 1 and 2, the variables are described herein.

## Description

### BACKGROUND

### FIELD

Embodiments of the invention relate generally to display devices, and more particularly, a metal oxide composition, a method of manufacturing a light-emitting device using the metal oxide composition, and the light-emitting device.

### DISCUSSION OF THE BACKGROUND

Light-emitting devices are devices that convert electrical energy into light energy. Examples of such light-emitting devices include organic light-emitting devices that use organic materials as a light-emitting material, quantum dot light-emitting devices that use quantum dots as a light-emitting material, and the like.

Light-emitting devices may include a first electrode on a substrate, and a hole transport region, an emission layer, an electron transport region, and a second electrode sequentially stacked on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transition from an excited state to a ground state to thereby generate light.

The above information disclosed in this Background section is only for understanding of the background of the inventive concepts, and, therefore, it may contain information that does not constitute prior art.

### SUMMARY

Metal oxide compositions made according to the principles and illustrative embodiments of the invention may reduce oxygen vacancy on the surface of the metal oxide, and accordingly, a light-emitting device manufactured from the metal oxide composition may exhibit excellent driving characteristics, e.g., a low driving voltage, improved electron injection and transport efficiency, luminescence efficiency, and lifespan.

Additional features of the inventive concepts will be set forth in the description which follows, and in part will be apparent from the description, or may be learned by practice of the inventive concepts.

According to one aspect of the invention, a metal oxide composition includes: a solvent; a metal oxide; and a hydrogen cation source including a compound of Formula 1, a compound of Formula 2, or any combination thereof: 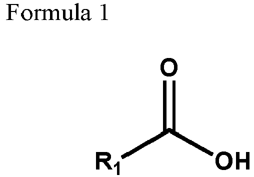 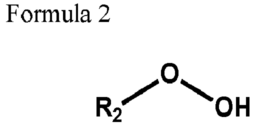 wherein, in Formulae 1 and 2, the variables are described herein.

The groups R₁ and R₂ may each be, independently from one another, as described herein.

The hydrogen cation source may be one of Compounds 1 to 7 or any combination thereof, as described herein.

The metal oxide may be of Formula 3, as described herein.

The metal oxide may be of Formula 4, as described herein.

The group M₂ in Formula 4 may be Mg, Co, Ni, Zr, Mn, Sn, Y, Al, Si, or Yb.

The content of the hydrogen cation source may be in a range of about 0.01 wt% to about 30 wt%, based on a total weight of the metal oxide.

According to another aspect of the invention, a method of manufacturing a light-emitting device includes: forming, on a first electrode, an emission layer including quantum dots; forming a metal oxide layer by providing, on the emission layer, the metal oxide composition as described herein; and forming a second electrode on the metal oxide layer.

The forming of the emission layer may include providing, on the first electrode, the quantum dot composition (comprising quantum dots) and a solvent; and removing the solvent.

The forming of the metal oxide layer may include providing, on the emission layer, the metal oxide composition; and removing the solvent.

After the forming of the second electrode, the light-emitting device may be heat-treated at a temperature in a range of about 50 °C to about 150 °C.

The heat-treating may be performed for about 10 hours to about 100 hours.

According to another aspect of the invention, a light-emitting device includes: a first electrode; a second electrode facing the first electrode; an emission layer between the first electrode and the second electrode; and a metal oxide layer between the emission layer and the second electrode, wherein the emission layer may include quantum dots, and the metal oxide layer may include: a metal oxide; and a hydrogen cation source including a compound of Formula 1, a compound of Formula 2, or any combination thereof: 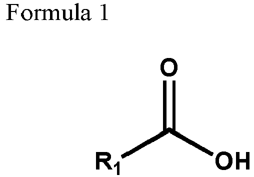 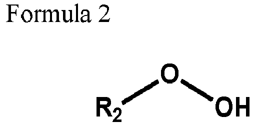 wherein, in Formulae 1 and 2, the variables are described herein.

The quantum dots in the emission layer may include a semiconductor compound of Groups II-VI, a semiconductor compound of Groups III-V, a semiconductor compound of Groups III-VI, a semiconductor compound of Groups I, III, and VI, a semiconductor compound of Groups IV-VI, an element or a compound of Group IV, or any combination thereof.

The quantum dots may have a core-shell structure.

The first electrode may include an anode, the second electrode may include a cathode, the light-emitting device may further include: a hole transport region between the first electrode and the emission layer; and an electron transport region between the emission layer and the second electrode, and the electron transport region may include the metal oxide layer.

The electron transport region may include at least one layer of a buffer layer, a hole blocking layer, an electron control layer, an electron transport layer, and an electron injection layer, and the metal oxide layer may include the buffer layer, the hole blocking layer, the electron transport layer, or the electron injection layer.

The metal oxide of the metal oxide layer may include a zinc-containing oxide.

The metal oxide of the metal oxide layer may include ZnO, ZnMgO, ZnAlO, ZnSiO, ZnYbO, TiO₂, WO₃, W₂O₃, WO₂, or any combination thereof.

At least some of the above and other features of the invention are set out in the claims.

It is to be understood that both the foregoing general description and the following detailed description are illustrative and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate illustrative embodiments of the invention, and together with the description serve to explain the inventive concepts.
FIG. 1 is a schematic cross-sectional view of an embodiment of a light-emitting device constructed according to the principles of the invention.
FIG. 2 is a schematic cross-sectional view of an embodiment of a light-emitting apparatus including a light-emitting device constructed according to the principles of the invention.
FIG. 3 is a schematic cross-sectional view of another embodiment of a light-emitting apparatus including a light-emitting device constructed according to the principles of the invention.

### DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing illustrative features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements, and duplicative explanations are omitted to avoid redundancy.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of idealized embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

According to one aspect of the invention, a metal oxide composition made according to one or more embodiments is described below.

### Metal oxide composition

The metal oxide composition includes: a solvent; a metal oxide; and a hydrogen cation source including a compound represented by Formula 1, a compound represented by Formula 2, or any combination thereof: 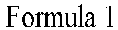 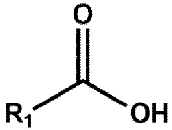 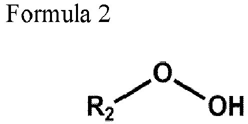 wherein, in Formulae 1 and 2,
R₁ and R₂ are each independently hydrogen, deuterium, -F, -Cl, -Br, -I, a hydroxyl group, a cyano group, a nitro group, a C₁-C₆₀ *(e.g.* C₁-C₂₀) alkyl group unsubstituted or substituted with at least one R₁₀ₐ, a C₂-C₆₀ *(e.g.* C₂-C₂₀) alkenyl group unsubstituted or substituted with at least one R₁₀ₐ, a C₂-C₆₀ *(e.g.* C₂-C₂₀) alkynyl group unsubstituted or substituted with at least one R₁₀ₐ, a C₁-C₆₀ *(e.g.* C₁-C₂₀) alkoxy group unsubstituted or substituted with at least one R₁₀ₐ, a C₃-C₆₀ *(e.g.* C₃-C₃₀) carbocyclic group unsubstituted or substituted with at least one R₁₀ₐ, a C₁-C₆₀ *(e.g.* C₁-C₂₀) heterocyclic group unsubstituted or substituted with at least one R₁₀ₐ, a C₆-C₆₀ *(e.g.* C₆-C₃₀) aryloxy group unsubstituted or substituted with at least one R₁₀ₐ, a C₆-C₆₀ *(e.g.* C₆-C₃₀) arylthio group unsubstituted or substituted with at least one R₁₀ₐ, - Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂), and
R₁₀ₐ is:
   deuterium, -F, -Cl, -Br, -I, a hydroxyl group, a cyano group, or a nitro group; a C₁-C₆₀ *(e.g.* C₁-C₂₀) alkyl group, a C₂-C₆₀ *(e.g.* C₂-C₂₀) alkenyl group, a C₂-C₆₀ *(e.g.* C₂-C₂₀) alkynyl group, or a C₁-C₆₀ *(e.g.* C₁-C₂₀) alkoxy group, each, independently from one another, unsubstituted or substituted with deuterium, -F, -Cl, -Br, -I, a hydroxyl group, a cyano group, a nitro group, a C₃-C₆₀ *(e.g.* C₃-C₃₀) carbocyclic group, a C₁-C₆₀ *(e.g.* C₁-C₂₀) heterocyclic group, a C6-C60 *(e.g.* C₆-C₃₀) aryloxy group, a C₆-C₆₀ *(e.g.* C₆-C₃₀) arylthio group, a C₇-C₆₀ *(e.g.* C₇-C₃₀) aryl alkyl group, a C₂-C₆₀ *(e.g.* C₂-C₂₀) heteroaryl alkyl group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
   a C₃-C₆₀ *(e.g.* C₃-C₃₀) carbocyclic group, a C₁-C₆₀ *(e.g.* C₁-C₂₀) heterocyclic group, a C₆₋C₆₀ *(e.g.* C₆-C₃₀) aryloxy group, a C₆-C₆₀ *(e.g.* C₆-C₃₀) arylthio group, a C₇-C₆₀ *(e.g.* C₇-C₃₀) aryl alkyl group, or a C₂-C₆₀ *(e.g.* C₂-C₂₀) heteroaryl alkyl group, each, independently from one another, unsubstituted or substituted with deuterium, -F, -Cl, -Br, -I, a hydroxyl group, a cyano group, a nitro group, a C₁-C₆₀ *(e.g.* C₁-C₂₀) alkyl group, a C₂-C₆₀ *(e.g.* C₂-C₂₀) alkenyl group, a C₂-C₆₀ *(e.g.* C₂-C₂₀) alkynyl group, a C₁-C₆₀ *(e.g.* C₁-C₂₀) alkoxy group, a C₃-C₆₀ *(e.g.* C₃-C₃₀) carbocyclic group, a C₁-C₆₀ *(e.g.* C₁-C₂₀) heterocyclic group, a C₆-C₆₀ *(e.g.* C₆-C₃₀) aryloxy group, a C₆-C₆₀ *(e.g.* C₆-C₃₀) arylthio group, a C₇-C₆₀ (*e.g.* C₇-C₃₀) aryl alkyl group, a C₂-C₆₀ *(e.g.* C₂-C₂₀) heteroaryl alkyl group,
   -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
   -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or -P(=O)(Q₃₁)(Q₃₂),
   wherein Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ *(e.g.* C₁-C₂₀) alkyl group; a C₂-C₆₀ *(e.g.* C₂-C₂₀) alkenyl group; a C₂-C₆₀ *(e.g.* C₂-C₂₀) alkynyl group; a C₁-C₆₀ *(e.g.* C₁-C₂₀) alkoxy group; a C₃-C₆₀ *(e.g.* C₃-C₃₀) carbocyclic group; or a C₁-C₆₀ *(e.g.* C₁-C₂₀) heterocyclic group, each, independently from one another, unsubstituted or substituted with deuterium, -F, a cyano group, a C₁-C₆₀ *(e.g.* C₁-C₂₀) alkyl group, a C₁-C₆₀ *(e.g.* C₁-C₂₀) alkoxy group, a phenyl group, a biphenyl group, or any combination thereof; a C₇-C₆₀ (*e.g.* C₇-C₃₀) aryl alkyl group; or a C₂-C₆₀ *(e.g.* C₂-C₂₀) heteroaryl alkyl group.

In one or more embodiments, in Formulae 1 and 2, R₁ and R₂ may each independently be: deuterium, -F, -Cl, -Br, -I, a hydroxyl group, a cyano group, or a nitro group; a C₁-C₂₀ *(e.g.* C₁-C₁₀) alkyl group or a C₂-C₂₀ (*e.g.* C₂-C₁₀) alkenyl group, each, independently from one another, unsubstituted or substituted with deuterium, -F, -Cl, -Br, -I, a hydroxyl group, a cyano group, a nitro group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, a triazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzoxazolyl group, a benzothiazolyl group, a dibenzofuranyl group, a dibenzothiophenyl group, a dibenzosilolyl group, a carbazolyl group, a benzocarbazolyl group, a dibenzocarbazolyl group,

-Si(Q₁₁)(Q₁₂)(Q₁₃), -N(Q₁₁)(Q₁₂), -B(Q₁₁)(Q₁₂), or any combination thereof; or a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, a triazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzoxazolyl group, a benzothiazolyl group, a dibenzofuranyl group, a dibenzothiophenyl group, a dibenzosilolyl group, a carbazolyl group, a benzocarbazolyl group, or a dibenzocarbazolyl group, each unsubstituted or substituted with deuterium, -F, -Cl, -Br, -I, a hydroxyl group, a cyano group, a nitro group, a C₁-C₂₀ *(e.g.* C₁-C₁₀) alkyl group, a C₂-C₂₀ *(e.g.* C₂-C₁₀) alkenyl group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, a triazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzoxazolyl group, a benzothiazolyl group, a dibenzofuranyl group, a dibenzothiophenyl group, a dibenzosilolyl group, a carbazolyl group, a benzocarbazolyl group, a dibenzocarbazolyl group, -Si(Q₁₁)(Q₁₂)(Q₁₃), -N(Q₁₁)(Q₁₂), - B(Q₁₁)(Q₁₂), or any combination thereof.

In one or more embodiments, in Formulae 1 and 2, R₁ and R₂ may each independently be: a methyl group, an ethyl group, a propyl group, an iso-propyl group, an n-butyl group, an isobutyl group, a sec-butyl group, a tert-butyl group, an n-pentyl group, an isopentyl group, a tert-pentyl group, a neo-pentyl group, a sec-pentyl group, a 3-pentyl group, a sec-isopentyl group, an n-hexyl group, an iso-hexyl group, a sec-hexyl group, a tert-hexyl group, a vinyl group, a 2-prophenyl group, an isoprophenyl group, a butenyl group, or a pentenyl group, each unsubstituted or substituted with deuterium, -F, -Cl, -Br, -I, a hydroxyl group, a cyano group, a nitro group, a cyclopentyl group, a cyclohexyl group, a cycloheptyl group, a cyclopentenyl group, a cyclohexenyl group, a phenyl group, a naphthyl group, or any combination thereof; or a cyclopentyl group, a cyclohexyl group, a cycloheptyl group, a cyclopentenyl group, a cyclohexenyl group, a phenyl group, a biphenyl group, a terphenyl group, or a naphthyl group, each unsubstituted or substituted with deuterium, -F, -Cl, -Br, -I, a hydroxyl group, a cyano group, a nitro group, a methyl group, an ethyl group, a propyl group, an iso-propyl group, an n-butyl group, an isobutyl group, a sec-butyl group, a tert-butyl group, an n-pentyl group, an isopentyl group, a tert-pentyl group, a neo-pentyl group, a sec-pentyl group, a 3-pentyl group, a sec-isopentyl group, an n-hexyl group, an iso-hexyl group, a sec-hexyl group, a tert-hexyl group, a vinyl group, 2-propenyl group, an isopropenyl group, a butenyl group, a pentenyl group, a cyclopentyl group, a cyclohexyl group, a cycloheptyl group, a cyclopentenyl group, a cyclohexenyl group, a phenyl group, a naphthyl group, or any combination thereof.

For example, in Formulae 1 and 2, R₁ and R₂ may each independently be: a methyl group, an ethyl group, a propyl group, an iso-propyl group, an n-butyl group, an isobutyl group, a sec-butyl group, a tert-butyl group, a vinyl group, a 2-propenyl group or an isopropenyl group, each unsubstituted or substituted with deuterium, -F, -Cl, -Br, -I, a hydroxyl group, a cyano group, a nitro group, a phenyl group, or any combination thereof; or a phenyl group, a biphenyl group, or a terphenyl group, each a unsubstituted or substituted with deuterium, -F, -Cl, -Br, -I, a hydroxyl group, a cyano group, a nitro group, a methyl group, an ethyl group, a propyl group, an iso-propyl group, an n-butyl group, an isobutyl group, a sec-butyl group, a tert-butyl group, a vinyl group, a 2-prophenyl group, an isoprophenyl group, a phenyl group, or any combination thereof.

In some embodiments, the hydrogen cation source is one of Compounds 1 to 7 or any combination thereof.

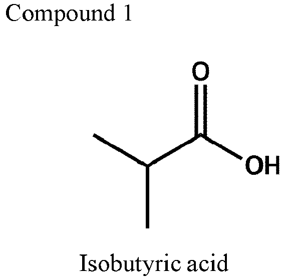

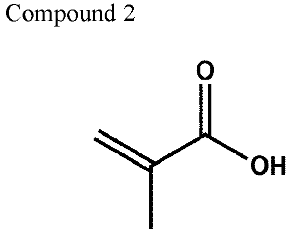

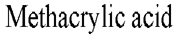

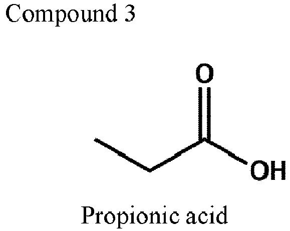

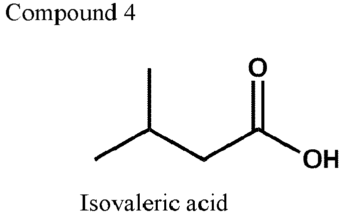

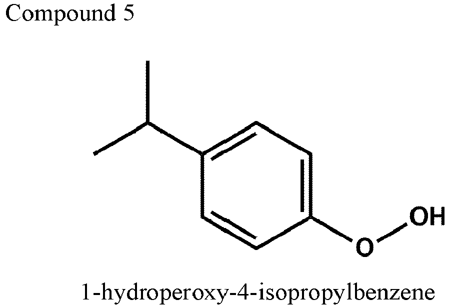

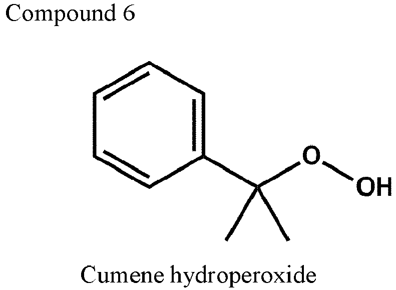

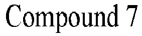

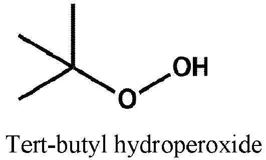

In one or more embodiments, the metal oxide may be represented by Formula 3: Formula 3
MₓO_{y}
wherein, in Formula 3,
M is Zn, Ti, Zr, Sn, W, Ta, Ni, Mo, or Cu, and
x and y are each independently an integer from 1 to 5.

For example, M may be Zn. For example, M may be Zn, and x and y may each be 1.

In one or more embodiments, the metal oxide may be represented by Formula 4: Formula 4
Zn_{1-z}(M₂)_{z}O_{y'}
wherein, in Formula 4,
M₂ is a metal other than zinc (Zn),
0≤z≤0.5, and
0≤y'≤2.

For example, M₂ in Formula 4 may be Mg, Co, Ni, Zr, Mn, Sn, Y, Al, Si, or Yb. For example, M₂ in Formula 4 may be Mg, and z may be 0.5. In one or more embodiments, the metal oxide may be ZnO, TiO₂, ZrO₂, SnO₂, WO₃, W₂O₃, WO₂, Ta₂O₅, NiO, MoO₂, MoO₃, CuO, Cu₂O, ZnMgO, ZnCoO, ZnMnO, ZnSnO, ZnAlO, ZnSiO, ZnYbO, or any combination thereof. In one or more embodiments, the metal oxide may be a zinc-containing oxide. In one or more embodiments, the metal oxide may be ZnO, ZnMgO, ZnAlO, ZnSiO, ZnYbO, TiO₂, WO₃, W₂O₃, WO₂, or any combination thereof.

In one or more embodiments, an average diameter of the metal oxide may be in a range of about 1 nanometers (nm) to about 30 nm, for example, about 5 nm to about 15 nm. The average diameter of the metal oxide may be measured by using a dynamic light scattering (DLS) method. For example, the metal oxide may be in a generally spherical shape, for example, a substantially spherical shape.

In a metal oxide nanoparticle, for example, a metal oxide nanoparticle such as ZnO, multiple oxygen vacancies may be present in a crystal thereof. Due to oxygen vacancy in the nanoparticle, the inside of the nanoparticle may be a n-type, and the nanoparticle may have a high electrical conductivity. In addition, an energy level of a conduction band of the metal oxide nanoparticle may be similar with an energy level of a conduction band of quantum dots. Thus, the metal oxide nanoparticle may have excellent electron injection characteristics, and the metal oxide layer including the metal oxide nanoparticle may be used as an electron injection layer or an electron transport layer in a quantum dot light-emitting device.

Although not wanting to be bound by theory, due to an energy level caused by oxygen vacancy on the surface of the metal oxide nanoparticle, the oxygen vacancy on the surface may serve as an electron trap. Accordingly, electrons injected from an electron injection electrode may be trapped on the surface of the nanoparticle. Thus, electrons may not be injected into the emission layer, thus deteriorating electron injection efficiency and electron transport efficiency. In addition, defect-assisted non-radiative recombination or Auger-type non-radiative recombination may occur in a quantum dot emission layer adjacent to the metal oxide layer, thus deteriorating luminescence efficiency.

The metal oxide composition according to one or more embodiments may include a hydrogen cation source, and thus, the hydrogen cation source may release H⁺ ions and form hydroxide (-OH) groups on the surface of the metal oxide. The -OH group may be formed in the active oxygen-adsorbing site of the surface of the metal oxide. As the active oxygen-adsorbing site serves as an electron-trapping site, the number of electron-trapping sites on the surface of the metal oxide of the metal oxide layer prepared by using the metal oxide composition may be reduced, and thus, electron injection efficiency into the emission layer may be increased. In addition, non-radiative recombination of the quantum dot emission layer adjacent to the metal oxide layer may be reduced.

In one or more embodiments, when the metal oxide composition is used for manufacturing a light-emitting device, the electrical characteristics change over the driving time of the light-emitting device depending on a chemical reaction such as oxygen adsorption on the surface of the metal oxide may be solved or reduced. Accordingly, the light-emitting device manufactured by using the metal oxide composition may exhibit excellent driving characteristics, e.g., a low driving voltage, high efficiency, and/or long lifespan.

In one or more embodiments, a content of the hydrogen cation source in the metal oxide composition may be in a range of about 0.01 weight percent (wt%) to about 30 wt%, for example, about 0.1 wt% to about 10 wt%, or for example about 0.1 wt% to about 5 wt%, based on the total weight of the metal oxide, but embodiments are not limited thereto. In one or more embodiments, a content of the metal oxide composition metal oxide may be in a range of about 0.5 wt% to about 20 wt%, or for example, about 1 wt% to about 15 wt%, based on the total weight of the solvent, but embodiments are not limited thereto.

The metal oxide composition includes a solvent. The solvent may be any suitable solvent that may properly disperse the metal oxide and the hydrogen cation source, but embodiments are not limited thereto. For example, the solvent may be an organic solvent. In one or more embodiments, the solvent may be selected from an alcohol-based solvent, a chlorine-based solvent, an ether-based solvent, an ester-based solvent, a ketone-based solvent, an aliphatic hydrocarbon-based solvent, and an aromatic hydrocarbon-based organic solvent, but embodiments are not limited thereto.

In one or more embodiments, the solvent may include: an alcohol-based solvent such as methanol, ethanol, n-propanol, iso-propanol, n-butanol, iso-butanol, sec-butanol, or t-butanol; a chlorine-based solvent such as dichloromethane, 1,2-dichloroethane, 1,1,2-trichloroethane, chlorobenzene, or o-dichlorobenzene; an ether-based solvent such as tetrahydrofuran, dioxane, anisole, 4-methylanisole, or butyl phenylether; an ester-based solvent such as ethyl acetate, butyl acetate, methyl benzoate, ethyl benzoate, butyl benzoate, or phenyl benzoate; a ketone-based solvent such as acetone, methylethylketone, cyclohexanone, or acetophenone; an aliphatic hydrocarbon-based solvent such as cyclohexane, methylcyclohexane, n-pentane, n-hexane, n-heptane, n-octane, n-nonane, n-decane, dodecane, hexadecane, or oxadecane; an aromatic hydrocarbon-based solvent such as toluene, xylene, mesitylene, ethylbenzene, n-hexyl benzene, cyclohexyl benzene, trimethyl benzene, tetrahydronaphthalene; or any combination thereof, but embodiments are not limited thereto.

The content of the solvent in the metal oxide composition may be about 80 wt% or greater and about 99.5 wt% or lower, or for example, about 90 wt% or greater and 99 wt% or lower based on the weight of the metal oxide composition, but embodiments are not limited thereto. When the content is within any of these ranges, the metal oxide and hydrogen cation source in the metal oxide composition may be properly dispersed, and the solid concentration may be suitable for a solution process.

The metal oxide composition may have a viscosity in a range of about 1 centipoise (cP) to about 10 cP. When the viscosity of the metal oxide composition is within this range, the metal oxide composition may be suitable for use in the formation of a metal oxide layer of a light-emitting device by using a solution process. The metal oxide composition may have a surface tension in a range of about 10 dynes/cm to about 40 dynes/cm. When the surface tension of the metal oxide composition is within this range, the metal oxide composition may be suitable for use in formation of a metal oxide layer of a light-emitting device by using a solution process.

### Method of preparing light-emitting device

An illustrative method of manufacturing a light-emitting device includes: forming an emission layer including one or more quantum dots on a first electrode; forming a metal oxide layer by providing, on the emission layer, the metal oxide composition described above; and forming a second electrode on the metal oxide layer. In one or more embodiments, the forming of the emission layer may include providing, on the first electrode, a quantum dot composition including quantum dots and a solvent, and removing the solvent. After the quantum dot composition is provided on the first electrode, the solvent may be removed by vacuum or heat to form an emission layer, but embodiments are not limited thereto.

For example, the removing of the solvent may be performed at a predetermined temperature, for example, at about 50 °C to about 150 °C. For example, heat-treating may be performed under vacuum. The quantum dot composition may be provided on the first electrode to a thickness of about 10 nm to about 100 nm. In one or more embodiments, the forming of the metal oxide layer may include: providing, on the emission layer, the metal oxide composition described above; and removing the solvent.

After the metal oxide composition is provided on the emission layer, the solvent may be removed by vacuum or heat to form an emission layer, but embodiments are not limited thereto. For example, the removing of the solvent may be performed at a predetermined temperature, for example, at about 50 °C to about 150 °C. For example, heat-treating may be performed under vacuum.

The quantum dot composition and the metal oxide composition may be provided on the first electrode by using a solution process, but embodiments are not limited thereto. For example, the solution process may be a spin-coating method or an inkjet printing method, but embodiments are not limited thereto. The solvent may include an organic solvent as described above. The quantum dot composition and the metal oxide composition may be provided on the first electrode by using a solution process, but embodiments are not limited thereto. In some embodiments, the solution process may be performed by a spin-coating method, a casting method, a gravure coating method, a bar coating method, a roll coating method, a dip coating method, a spray coating method, a screen coating method, a flex printing method, an offset printing method, an inkjet printing method, or a nozzle printing method, but embodiments are not limited thereto.

In one or more embodiments, after the forming of the second electrode, heat-treating the light-emitting device at a temperature in a range of about 50 °C to about 150 °C may be further included. By additionally heat-treating the light-emitting device, an additional reaction in which unreacted hydrogen cations released from the hydrogen cation source form -OH groups on the surface of the metal oxide may occur. For example, the heat-treating may be performed for about 10 hours to about 100 hours.

### Light-emitting device

According to one or more embodiments, the light-emitting device includes a first electrode, a second electrode facing the first electrode, an emission layer between the first electrode and the second electrode, and a metal oxide layer between the emission layer and the second electrode, wherein the emission layer includes one or more quantum dots, and the metal oxide layer includes a metal oxide, a hydrogen cation source including a compound represented by Formula 1, a compound represented by Formula 2, or any combination thereof.

The quantum dots included in the emission layer may include a semiconductor compound of Groups II-VI, a semiconductor compound of Groups III-V, a semiconductor compound of Groups III-VI, a semiconductor compound of Groups I, III, and VI, a semiconductor compound of Groups IV-VI, an element or a compound of Group IV, or any combination thereof.

Examples of the semiconductor compound of Groups II-VI may include a binary compound such as CdS, CdSe, CdTe, ZnS, ZnSe, ZnTe, ZnO, HgS, HgSe, HgTe, MgSe, or MgS; a ternary compound such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, or MgZnS; a quaternary compound such as CdZnSeS, CdZnSeTe, CdZnSTe, CdHgSeS, CdHgSeTe, CdHgSTe, HgZnSeS, HgZnSeTe, or HgZnSTe; or any combination thereof.

Examples of the semiconductor compound of Groups III-V may include a binary compound such as GaN, GaP, GaAs, GaSb, AlN, AlP, AlAs, AlSb, InN, InP, InAs, or InSb; a ternary compound such as GaNP, GaNAs, GaNSb, GaPAs, GaPSb, AlNP, AINAs, AINSb, AlPAs, AlPSb, InGaP, InNP, InAIP, InNAs, InNSb, InPAs, or InPSb; a quaternary compound such as GaAlNP, GaAlNAs, GaAlNSb, GaAlPAs, GaAlPSb, GaInNP, GalnNAs, GalnNSb, GaInPAs, GaInPSb, InAlNP, InAlNAs, InAlNSb, InAlPAs, or InAlPSb; or any combination thereof. In some embodiments, the semiconductor compound of Groups III-V may further include an element of Group II. Examples of the semiconductor compound of Groups III-V further including the element of Group II may include InZnP, InGaZnP, InAlZnP, and the like.

Examples of the semiconductor compound of Groups III-VI may include a binary compound such as GaS, GaSe, Ga₂Se₃, GaTe, InS, InSe, In₂S₃, In₂Se₃, InTe, and the like; a ternary compound such as InGaS₃, InGaSe₃, and the like; or any combination thereof. Examples of the semiconductor compound of Groups I, III, and VI may include a ternary compound such as AgInS, AgInS₂, CuInS, CuInS₂, CuGaO₂, AgGaO₂, AgAlO₂, or any combination thereof.

Examples of the semiconductor compound of Groups IV-VI may include a binary compound such as SnS, SnSe, SnTe, PbS, PbSe, or PbTe; a ternary compound such as SnSeS, SnSeTe, SnSTe, PbSeS, PbSeTe, PbSTe, SnPbS, SnPbSe, or SnPbTe; a quaternary compound such as SnPbSSe, SnPbSeTe, or SnPbSTe; or any combination thereof. The element or compound of Group IV may be a single element material such as Si or Ge; a binary compound such as SiC or SiGe; or any combination thereof. Individual elements included in the multielement compound, such as a binary compound, a ternary compound, and a quaternary compound, may be present in a particle thereof at a uniform or non-uniform concentration.

The quantum dot may have a single structure in which the concentration of each element included in the quantum dot is uniform or a core-shell double structure. In some embodiments, materials included in the core may be different from materials included in the shell. In one or more embodiments, the core may include at least one of Zn, Te, Se, Cd, In, and P. For example, the core may include InP, InZnP, ZnSe, ZnTeS, ZnSeTe, or any combination thereof.

The shell of the quantum dot may serve as a protective layer for preventing chemical denaturation of the core to maintain semiconductor characteristics and/or as a charging layer for imparting electrophoretic characteristics to the quantum dot. The shell may be a monolayer or a multilayer. An interface between a core and a shell may have a concentration gradient where a concentration of elements present in the shell decreases toward the core.

Examples of the shell of the quantum dot include a metal, a metalloid, or a nonmetal oxide, a semiconductor compound, or a combination thereof. Examples of the metal oxide, metalloid, or nonmetal oxide may include: a binary compound such as SiO₂, Al₂O₃, TiO₂, ZnO, MnO, Mn₂O₃, Mn₃O₄, CuO, FeO, Fe₂O₃, Fe₃O₄, CoO, CO₃O₄, or NiO; a ternary compound such as MgAl₂O₄, CoFe₂O₄, NiFe₂O₄, or CoMn₂O₄; and any combination thereof. Examples of the semiconductor compound may include a semiconductor compound of Groups II-VI, a semiconductor compound of Groups III-V, a semiconductor compound of Groups III-VI, a semiconductor compound of Groups I, III, and VI, a semiconductor compound of Groups IV-VI, or any combination thereof. In some embodiments, the semiconductor compound may be CdS, CdSe, CdTe, ZnS, ZnSe, ZnTe, ZnSeS, ZnTeS, ZnSeTe, GaAs, GaP, GaSb, HgS, HgSe, HgTe, InAs, InP, InGaP, InSb, AlAs, AlP, AlSb, or any combination thereof. In one or more embodiments, the shell may have a composition different from the composition of the core, and the shell may include ZnS, ZnSe, ZnSeS, ZnTeS, ZnSeTe, or any combination thereof.

The quantum dots may each have a full width of half maximum (FWHM) of a spectrum of an emission wavelength of about 45 nm or less, about 40 nm or less, or about 30 nm or less. When the FWHM of the quantum dot is within this range, color purity or color reproducibility may be improved. In addition, because light emitted through the quantum dots is emitted in all directions, an optical viewing angle may be improved.

In an embodiment, an average diameter of the quantum dots may be in a range of about 1 nm to about 20 nm. When the average diameter of the quantum dots is within any of these ranges, specific behavior as quantum dots may be achieved, and excellent dispersibility of the composition may be obtained. In addition, the quantum dot may be specifically, a generally spherical, a generally pyramidal, a generally multi-armed, or a generally cubic nanoparticle, a generally nanotube-shaped, a generally nanowire-shaped, a generally nanofiber-shaped, or a generally nanoplate-shaped particle.

By adjusting the size of the quantum dot, the energy band gap may also be adjusted, thereby obtaining light of various wavelengths in the quantum dot emission layer. By using quantum dots of various sizes, a light-emitting device that may emit light of various wavelengths may be realized. In some embodiments, the size of the quantum dot may be selected such that the quantum dot may emit red, green, and/or blue light. In addition, the size of the quantum dot may be selected such that the quantum dot may emit white light by combining various light colors.

Quantum dots may be synthesized by a wet chemical process, an organic metal chemical vapor deposition process, a molecular beam epitaxy process, or any similar process. The wet chemical process is a method of growing a quantum dot particle crystal by mixing a precursor material with an organic solvent. When the crystal grows, the organic solvent may naturally serve as a dispersant coordinated on the surface of the quantum dot crystal and control the growth of the crystal. Thus, the wet chemical method may be easier to perform than the vapor deposition process such a metal organic chemical vapor deposition (MOCVD) or a molecular beam epitaxy (MBE) process. Further, the growth of quantum dot particles may be controlled with a lower manufacturing cost.

In some embodiments, the emission layer may include a monolayer of quantum dots. In some embodiments, the emission layer may include a monolayer of quantum dots from about 2 layers to about 20 layers. The thickness of the emission layer may be in a range of about 5 nm to about 200 nm, about 10 nm to about 150 nm, or for example, about 10 nm to about 100 nm. For example, the metal oxide layer may be a layer formed by using the metal oxide composition according to one or more embodiments.

In one or more embodiments, the first electrode may be an anode, the second electrode may be a cathode, the light-emitting device may further include a hole transport region between the first electrode and the emission layer and an electron transport region between the emission layer and the second electrode, and the electron transport region may include the metal oxide layer. The electron transport region may include at least one layer of a buffer layer, a hole blocking layer, an electron control layer, an electron transport layer, and an electron injection layer. The metal oxide layer may be at least one of the buffer layer, the hole blocking layer, the electron transport layer, and the electron injection layer.

The thickness of the metal oxide layer may be in a range of about 5 nm to about 200 nm, about 10 nm to about 150 nm, or for example, about 10 nm to about 100 nm. Accordingly, upon formation of the second electrode, damage to the emission layer may be prevented.

In one or more embodiments, the surface of the metal oxide may include -OH groups. The -OH groups on the surface may be formed by reduction of oxygen adsorbed to oxygen vacancy of the metal oxide by hydrogen cation (H⁺) ions released from the hydrogen cation source. In one or more embodiments, the metal oxide may be a zinc-containing oxide. For example, the metal oxide may be a zinc-containing oxide including -OH groups on a surface thereof. For example, the zinc-containing oxide may be a zinc oxide or a magnesium zinc oxide.

In one or more embodiments, the metal oxide may be ZnO, ZnMgO, ZnAlO, ZnSiO, ZnYbO, TiO₂, WO₃, W₂O₃, WO₂, or any combination thereof. For example, the metal oxide may be ZnO, ZnMgO, ZnAlO, ZnSiO, ZnYbO, TiO₂, WO₃, W₂O₃, WO₂, or any combination thereof, including -OH groups.

The metal oxide may have -OH groups on a surface thereof due to the hydrogen cation source included in the metal oxide layer. Accordingly, a light-emitting device including the metal oxide layer may have an increased electron injection efficiency into the emission layer, and non-radiative recombination may be reduced in the quantum dot emission layer adjacent to the metal oxide layer. Accordingly, the light-emitting device may exhibit excellent driving characteristics, e.g., a low driving voltage, high efficiency, and/or long lifespan.

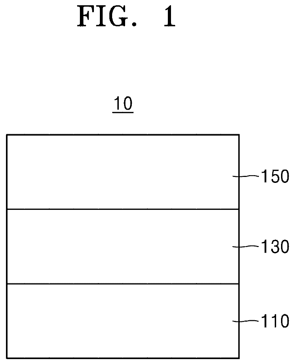

### Description of FIG. 1

FIG. 1 is a schematic cross-sectional view of an embodiment of a light-emitting device constructed according to the principles of the invention. Particularly, FIG. 1 is a schematic view of a light-emitting device 10 according to an embodiment. The light-emitting device 10 may include a first electrode 110, an interlayer 130, and a second electrode 150.

Hereinafter, the structure of the light-emitting device 10 according to an embodiment and an illustrative method of manufacturing the light-emitting device 10 according to an embodiment will be described in connection with FIG. 1.

### First electrode 110

In FIG. 1, a substrate may be additionally located under the first electrode 110 or above the second electrode 150. The substrate may be a glass substrate or a plastic substrate. The substrate may be a flexible substrate including plastic having excellent heat resistance and durability, for example, a polyimide, a polyethylene terephthalate (PET), a polycarbonate, a polyethylene naphthalate, a polyarylate (PAR), a polyetherimide, or any combination thereof.

The first electrode 110 may be formed by depositing or sputtering, on the substrate, a material for forming the first electrode 110. When the first electrode 110 is an anode, a high work function material that may easily inject holes may be used as a material for a first electrode.

The first electrode 110 may be a reflective electrode, a semi-transmissive electrode, or a transmissive electrode. When the first electrode 110 is a transmissive electrode, a material for forming the first electrode 110 may be an indium tin oxide (ITO), an indium zinc oxide (IZO), a tin oxide (SnO₂), a zinc oxide (ZnO), or any combinations thereof. In some embodiments, when the first electrode 110 is a semi-transmissive electrode or a reflective electrode, magnesium (Mg), silver (Ag), aluminium (Al), aluminium-lithium (Al-Li), calcium (Ca), magnesium-indium (Mg-In), magnesium-silver (Mg-Ag), or any combination thereof may be used as a material for forming the first electrode 110.

The first electrode 110 may have a single-layered structure consisting of a single layer or a multi-layered structure including two or more layers. In some embodiments, the first electrode 110 may have a triple-layered structure of an ITO/Ag/ITO.

### Interlayer 130

The interlayer 130 may be on the first electrode 110. The interlayer 130 may include an emission layer. The interlayer 130 may further include a hole transport region between the first electrode 110 and the emission layer and an electron transport region between the emission layer and the second electrode 150. The interlayer 130 may further include metal-containing compounds such as organometallic compounds, inorganic materials such as quantum dots, and the like, in addition to various organic materials.

The interlayer 130 may include: i) at least two emitting units sequentially stacked between the first electrode 110 and the second electrode 150; and ii) a charge generation layer located between the at least two emitting units. When the interlayer 130 includes the at least two emitting units and a charge generation layer, the light-emitting device 10 may be a tandem light-emitting device.

### Hole transport region in interlayer 130

The hole transport region may have i) a single-layered structure consisting of a single layer consisting of a single material, ii) a single-layered structure consisting of a single layer including a plurality of different materials, or iii) a multi-layered structure having a plurality of layers including a plurality of different materials. The hole transport region may include a hole injection layer, a hole transport layer, an emission auxiliary layer, an electron blocking layer, or a combination thereof.

For example, the hole transport region may have a multi-layered structure, e.g., a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein layers of each structure are sequentially stacked on the first electrode 110 in each stated order.

The hole transport region may include the compound represented by Formula 201, the compound represented by Formula 202, or any combination thereof: 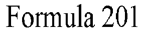 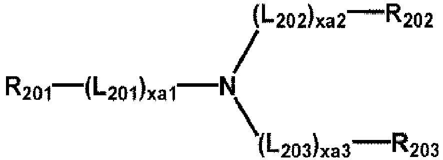 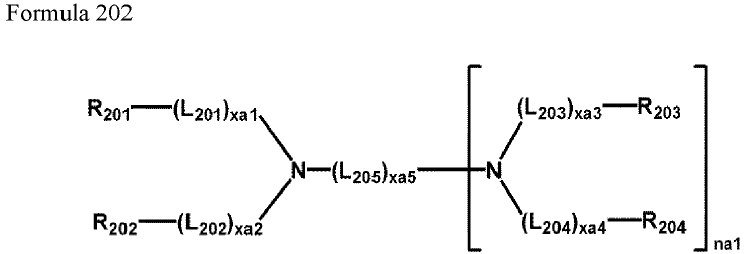 wherein, in Formulae 201 and 202,
L₂₀₁ to L₂₀₄ may each independently be a C₃-C₆₀ *(e.g.* C₃-C₃₀) carbocyclic group unsubstituted or substituted with at least one R₁₀ₐ or a C₁-C₆₀ *(e.g.* C₁-C₂₀) heterocyclic group unsubstituted or substituted with at least one R₁₀ₐ,
L₂₀₅ may be ^{∗}-O-^{∗}', ^{∗}-S-^{∗}', ^{∗}-N(Q₂₀₁)-^{∗}', a C₁-C₂₀ *(e.g.* C₁-C₁₀) alkylene group unsubstituted or substituted with at least one R₁₀ₐ, a C₂-C₂₀ (*e.g.* C₂-C₁₀) alkenylene group unsubstituted or substituted with at least one R₁₀ₐ, a C₃-C₆₀ *(e.g.* C₃-C₃₀) carbocyclic group unsubstituted or substituted with at least one R₁₀ₐ, or a C₁-C₆₀ *(e.g.* C₁-C₂₀) heterocyclic group unsubstituted or substituted with at least one R₁₀ₐ,
xa1 to xa4 may each independently be an integer from 0 to 5,
xa5 may be an integer from 1 to 10,
R₂₀₁ to R₂₀₄ and Q₂₀₁ may each independently be a C₃-C₆₀ *(e.g.* C₃-C₃₀) carbocyclic group unsubstituted or substituted with at least one R₁₀ₐ or a C₁-C₆₀ *(e.g.* C₁-C₂₀) heterocyclic group unsubstituted or substituted with at least one R₁₀ₐ,
R₂₀₁ and R₂₀₂ may optionally be bound to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ (*e.g.* C₈-C₃₀) polycyclic group (e.g., a carbazole group or the like) unsubstituted or substituted with at least one R₁₀ₐ (e.g., Compound HT16 described herein),
R₂₀₃ and R₂₀₄ may optionally be bound to each other via a single bond, a C₁-C₅ alkylene group unsubstituted or substituted with at least one R₁₀ₐ, or a C₂-C₅ alkenylene group unsubstituted or substituted with at least one R₁₀ₐ to form a C₈-C₆₀ (*e.g.* C₈-C₃₀) polycyclic group unsubstituted or substituted with at least one R₁₀ₐ, and
na1 may be an integer from 1 to 4.

In some embodiments, Formulae 201 and 202 may each include at least one of groups represented by Formulae CY201 to CY217: 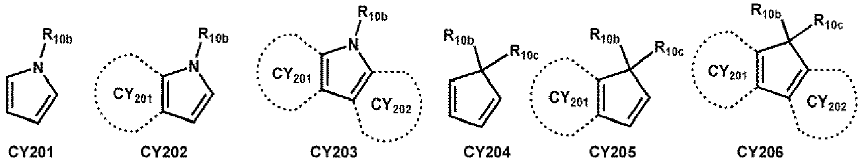 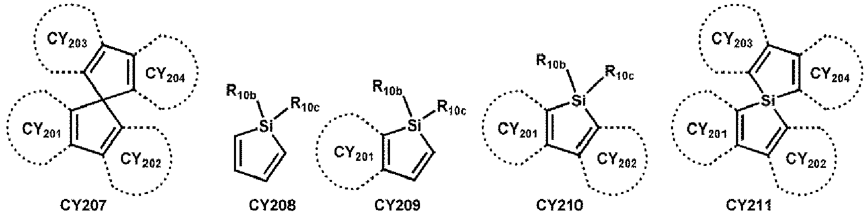 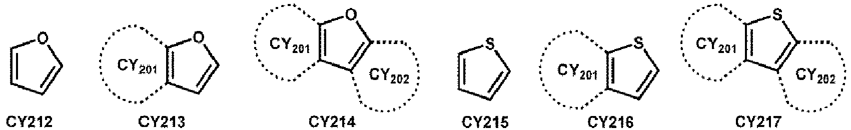 wherein, in Formulae CY201 to CY217, R_{10b} and R_{10c} may each be understood by referring to the descriptions of R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In some embodiments, in Formulae CY201 to CY217, ring CY₂₀₁ to ring CY₂₀₄ may each independently be a benzene group, a naphthalene group, a phenanthrene group, or an anthracene group. In one or more embodiments, Formulae 201 and 202 may each include at least one of groups represented by Formulae CY201 to CY203. In one or more embodiments, Formula 201 may include at least one of groups represented by Formulae CY201 to CY203 and at least one of groups represented by Formulae CY204 to CY217. In one or more embodiments, in Formula 201, xa1 may be 1, R₂₀₁ may be a group represented by any one of Formulae CY201 to CY203, xa2 may be 0, and R₂₀₂ may be a group represented by Formulae CY204 to CY207.

In one or more embodiments, Formulae 201 and 202 may each not include groups represented by Formulae CY201 to CY203. In one or more embodiments, Formulae 201 and 202 may each not include groups represented by Formulae CY201 to CY203, and include at least one of groups represented by Formulae CY204 to CY217. In one or more embodiments, Formulae 201 and 202 may each not include groups represented by Formulae CY201 to CY217.

In some embodiments, the hole transport region may include one of Compounds HT1 to HT46 and 4,4',4"-tris[phenyl(m-tolyl)amino]triphenylamine (m-MTDATA), 1-N,1-N-bis[4-(diphenylamino)phenyl]-4-N,4-N-diphenylbenzene-1,4-diamine (TDATA), 4,4',4"-tris[2-naphthyl(phenyl)amino]triphenylamine (2-TNATA), bis(naphthalen-1-yl)-N,N'-bis(phenyl)benzidine (NPB or NPD), N4,N4'-di(naphthalen-2-yl)-N4,N4'-diphenyl-[1,1'-biphenyl]-4,4'-diamine (β-NPB), N,N'-bis(3-methylphenyl)-N,N'-diphenylbenzidine (TPD), N,N'-bis(3-methylphenyl)-N,N'-diphenyl-9,9-spirobifluorene-2,7-diamine (spiro-TPD), N2,N7-di-1-naphthalenyl-N2,N7-diphenyl-9,9'-spirobi[9H-fluorene]-2,7-diamine (spiro-NPB), N,N'-di(1-naphthyl)-N,N'-diphenyl-2,2'-dimethyl-(1,1'-biphenyl)-4,4'-diamine (methylated-NPB), 4,4'-cyclohexylidenebis[N,N-bis(4-methylphenyl)benzenamine] (TAPC), N,N,N',N'-tetrakis(3-methylphenyl)-3,3'-dimethylbenzidine (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphorsulfonic acid (PANI/CSA), polyaniline/poly(4-styrenesulfonate (PANI/PSS), or any combination thereof:

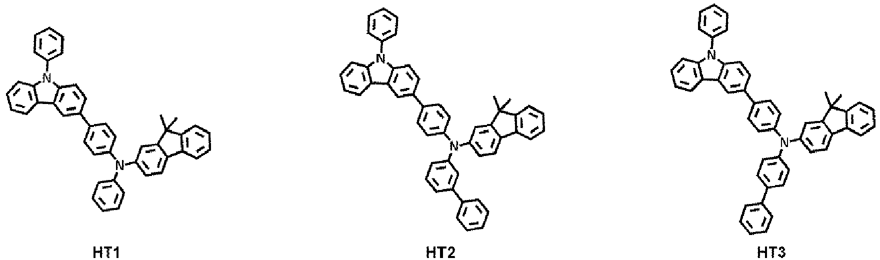

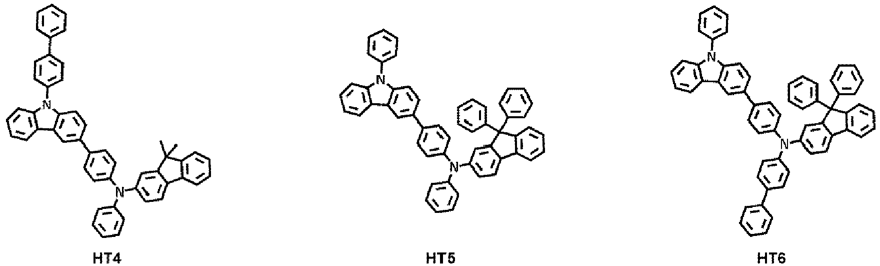

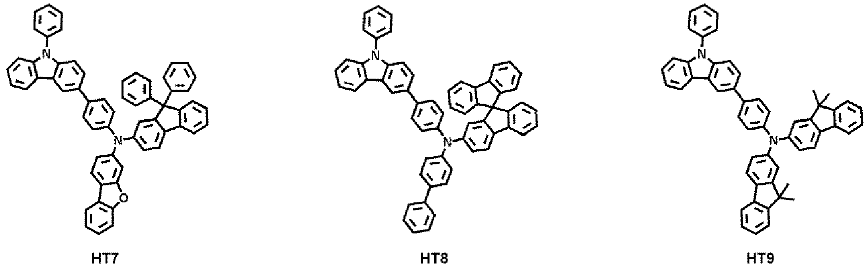

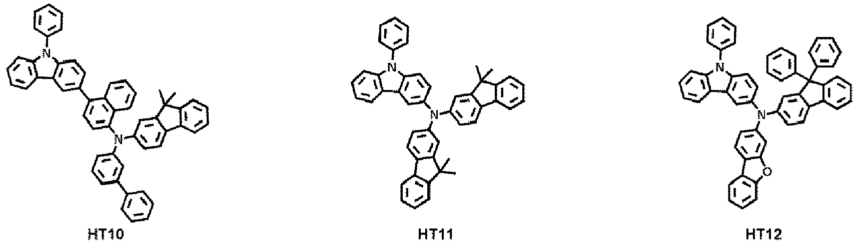

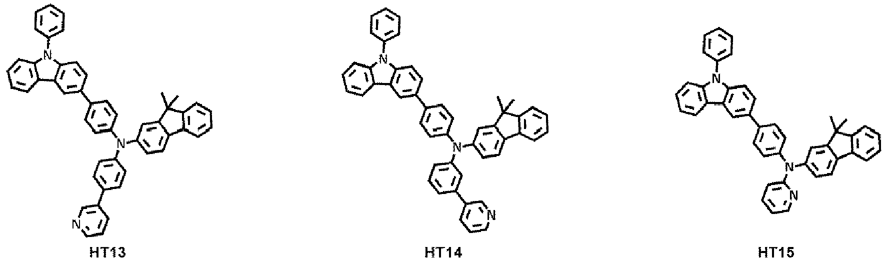

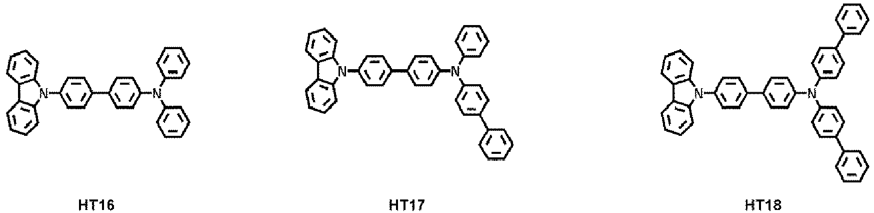

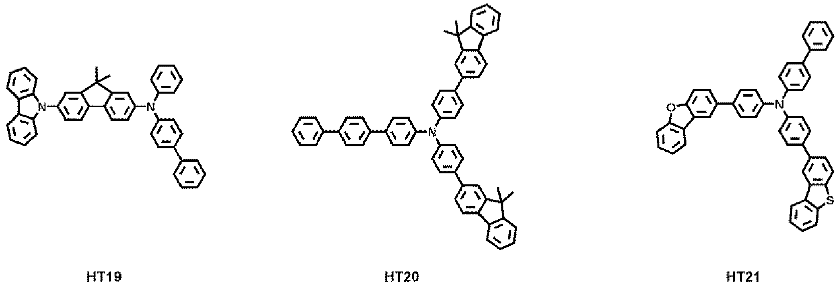

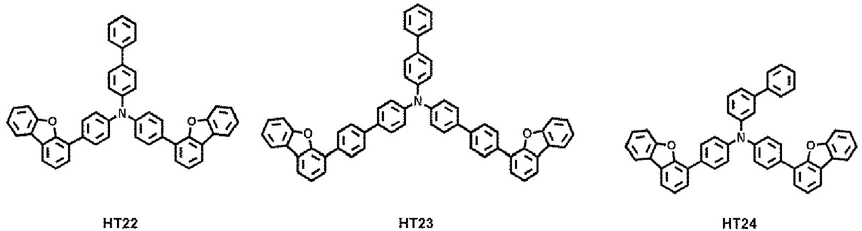

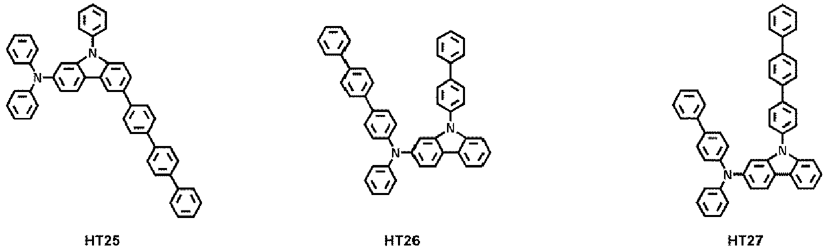

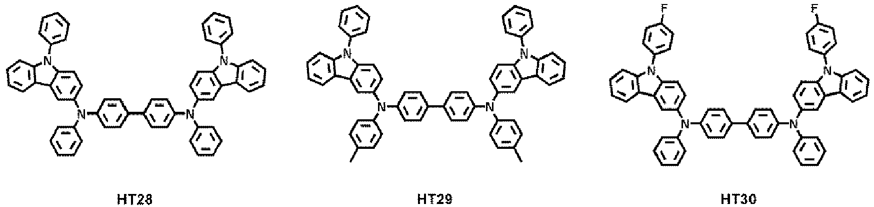

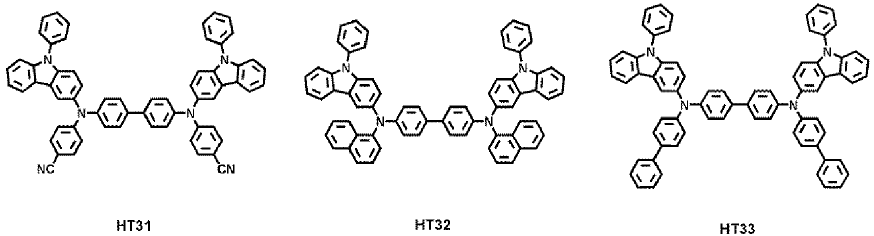

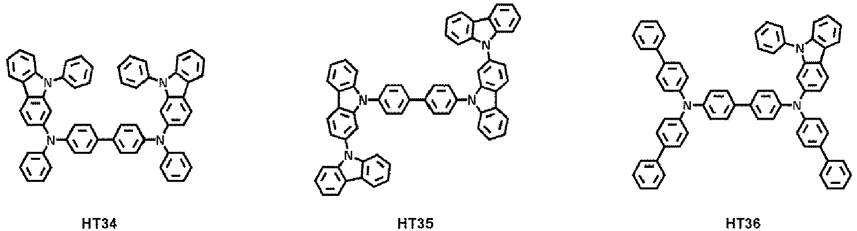

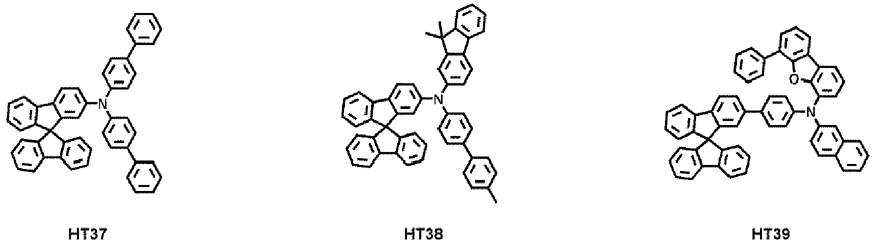

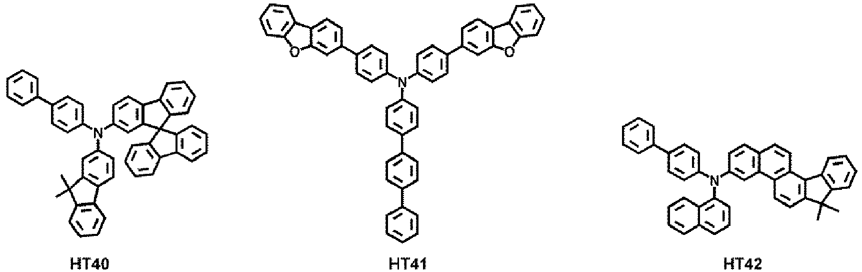

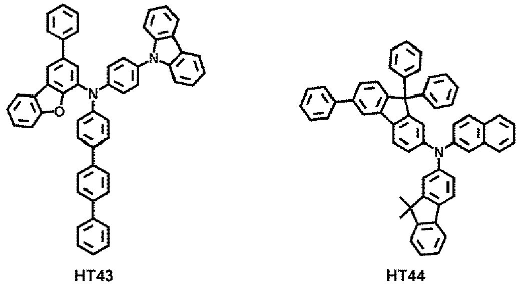

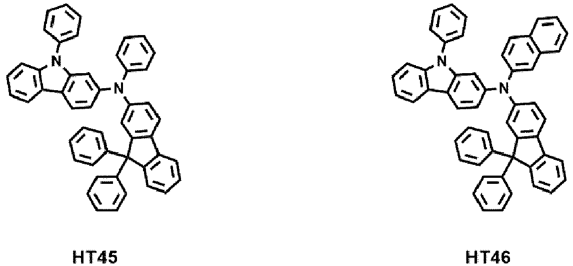

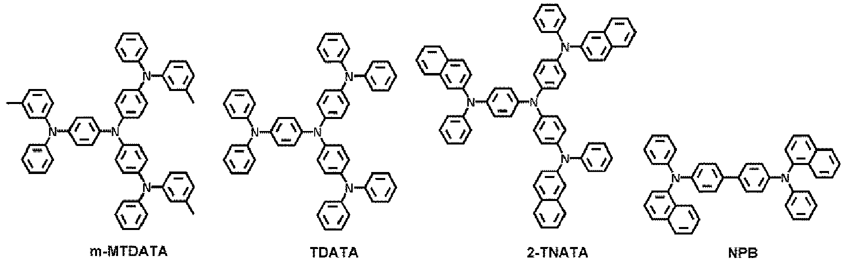

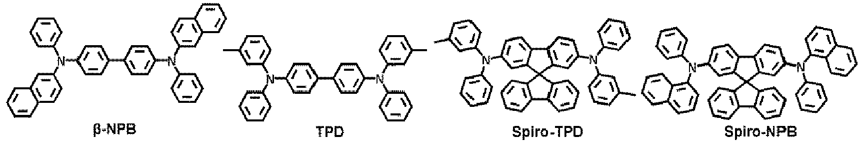

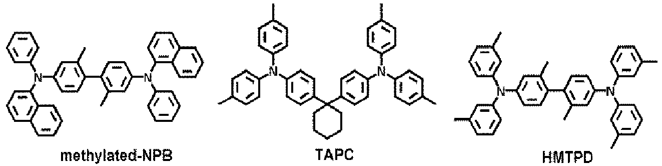

The thickness of the hole transport region may be in a range of about 50 Angstroms (Å) to about 10,000 Å, for example, about 100 Å to about 4,000 Å. When the hole transport region includes a hole injection layer, a hole transport layer, and any combination thereof, the thickness of the hole injection layer may be in a range of about 100 Å to about 9,000 Å, for example, about 100 Å to about 1,000 Å, the thickness of the hole transport layer may be in a range of about 50 Å to about 2,000 Å, for example, about 100 Å to about 1,500 Å. When the thicknesses of the hole transport region, the hole injection layer, and the hole transport layer are within any of these ranges, excellent hole transport characteristics may be obtained without a substantial increase in driving voltage.

The emission auxiliary layer may increase light emission efficiency by compensating for an optical resonance distance according to the wavelength of light emitted by an emission layer. The electron blocking layer may prevent leakage of electrons to a hole transport region from the emission layer. Materials that may be included in the hole transport region may also be included in an emission auxiliary layer and an electron blocking layer.

### p-dopant

The hole transport region may include a charge generating material as well as the aforementioned materials to improve conductive properties of the hole transport region. The charge generating material may be substantially homogeneously or non-homogeneously dispersed (for example, as a single layer consisting of charge generating material) in the hole transport region. The charge generating material may include, for example, a p-dopant. In some embodiments, a lowest unoccupied molecular orbital (LUMO) energy level of the p-dopant may be about -3.5 eV or less. In some embodiments, the p-dopant may include a quinone derivative, a compound containing a cyano group, a compound containing element EL1 and element EL2, or any combination thereof.

Examples of the quinone derivative may include tetracyanoquinodimethane (TCNQ), 2,3,5,6-tetrafluoro-7,7,8,8-tetracyanoquinodimethane (F4-TCNQ), and the like. Examples of the compound containing a cyano group include 1,4,5,8,9,12-hexaazatriphenylene-hexacarbonitrile (HAT-CN), a compound represented by Formula 221, and the like: 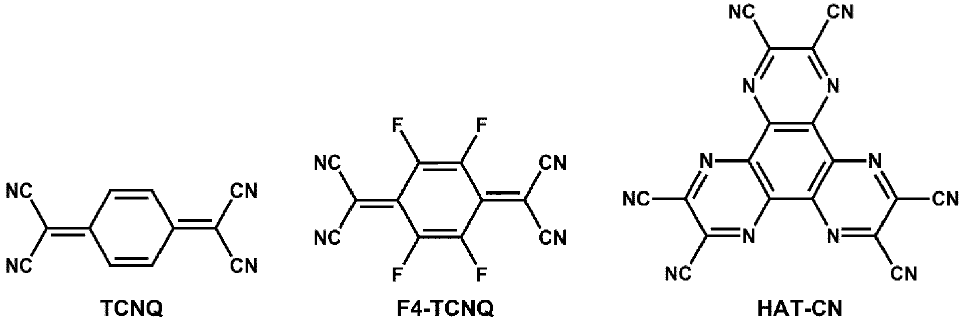 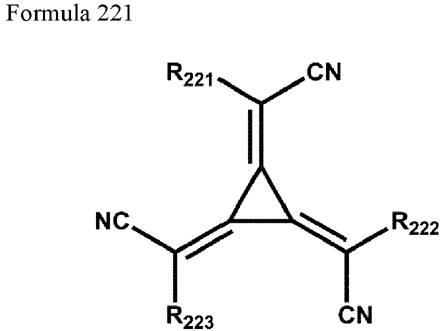 wherein, in Formula 221,
R₂₂₁ to R₂₂₃ may each independently be a C₃-C₆₀ *(e.g.* C₃-C₃₀) carbocyclic group unsubstituted or substituted with at least one R₁₀ₐ or a C₁-C₆₀ *(e.g.* C₁-C₂₀) heterocyclic group unsubstituted or substituted with at least one R₁₀ₐ, and at least one of R₂₂₁ to R₂₂₃ may each independently be: a C₃-C₆₀ *(e.g.* C₃-C₃₀) carbocyclic group or a C₁-C₆₀ *(e.g.* C₁-C₂₀) heterocyclic group, substituted with a cyano group; -F; -Cl; -Br; -I; a C₁-C₂₀ alkyl group substituted with a cyano group, -F, -Cl, -Br, -I, or any combination thereof; or any combination thereof.

In the compound containing element EL1 and element EL2, element EL1 may be a metal, a metalloid, or a combination thereof, and element EL2 may be a non-metal, a metalloid, or a combination thereof. Examples of the metal may include: an alkali metal (e.g., lithium (Li), sodium (Na), potassium (K), rubidium (Rb), cesium (Cs), or the like); an alkaline earth metal (e.g., beryllium (Be), magnesium (Mg), calcium (Ca), strontium (Sr), barium (Ba), or the like); a transition metal (e.g., titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), or the like); post-transition metal (e.g., zinc (Zn), indium (In), tin (Sn), or the like); a lanthanide metal (e.g., lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), or the like); and the like.

Examples of the metalloid may include silicon (Si), antimony (Sb), tellurium (Te), and the like. Examples of the non-metal may include oxygen (O), a halogen (e.g., F, Cl, Br, I, and the like), and the like. For example, the compound containing element EL1 and element EL2 may include a metal oxide, a metal halide (e.g., a metal fluoride, a metal chloride, a metal bromide, a metal iodide, and the like), a metalloid halide (e.g., a metalloid fluoride, a metalloid chloride, a metalloid bromide, a metalloid iodide, and the like), a metal telluride, or any combination thereof.

Examples of the metal oxide may include a tungsten oxide (e.g., WO, W₂O₃, WO₂, WO₃, W₂O₅, and the like), a vanadium oxide (e.g., VO, V₂O₃, VO₂, V₂O₅, and the like), a molybdenum oxide (MoO, Mo₂O₃, MoO₂, MoO₃, Mo₂O₅, and the like), a rhenium oxide (e.g., ReO₃ and the like), and the like. Examples of the metal halide may include an alkali metal halide, an alkaline earth metal halide, a transition metal halide, a post-transition metal halide, a lanthanide metal halide, and the like.

Examples of the alkali metal halide may include LiF, NaF, KF, RbF, CsF, LiCl, NaCl, KCl, RbCl, CsCl, LiBr, NaBr, KBr, RbBr, CsBr, LiI, NaI, KI, RbI, CsI, and the like. Examples of the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and the like. Examples of the transition metal halide may include a titanium halide (e.g., TiF₄, TiCl₄, TiBr₄, TiI₄, and the like), a zirconium halide (e.g., ZrF₄, ZrCl₄, ZrBr₄, ZrI₄, and the like), a hafnium halide (e.g., HfF₄, HfCl₄, HfBr₄, HfI₄, and the like), a vanadium halide (e.g., VF₃, VCl₃, VBr₃, VI₃, and the like), a niobium halide (e.g., NbF₃, NbCl₃, NbBr₃, Nbl₃, and the like), a tantalum halide (e.g., TaF₃, TaCl₃, TaBr₃, TaI₃, and the like), a chromium halide (e.g., CrF₃, CrCl₃, CrBr₃, CrI₃, and the like), a molybdenum halide (e.g., MoF₃, MoCl₃, MoBr₃, MoI₃, and the like), a tungsten halide (e.g., WF₃, WCl₃, WBr₃, Wl₃, and the like), a manganese halide (e.g., MnF₂, MnCl₂, MnBr₂, MnI₂, and the like), a technetium halide (e.g., TcF₂, TcCl₂, TcBr₂, TcI₂, and the like), a rhenium halide (e.g., ReF₂, ReCl₂, ReBr₂, ReI₂, and the like), an iron halide (e.g., FeF₂, FeCl₂, FeBr₂, FeI₂, and the like), a ruthenium halide (e.g., RuF₂, RuCl₂, RuBr₂, RuI₂, and the like), an osmium halide (e.g., OsF₂, OsCl₂, OsBr₂, OsI₂, and the like), a cobalt halide (e.g., CoF₂, CoCl₂, CoBr₂, CoI₂, and the like), a rhodium halide (e.g., RhF₂, RhCl₂, RhBr₂, RhI₂, and the like), an iridium halide (e.g., IrF₂, IrCl₂, IrBr₂, IrI₂, and the like), a nickel halide (e.g., NiF₂, NiCl₂, NiBr₂, NiI₂, and the like), a palladium halide (e.g., PdF₂, PdCl₂, PdBr₂, PdI₂, and the like), a platinum halide (e.g., PtF₂, PtCl₂, PtBr₂, PtI₂, and the like), a copper halide (e.g., CuF, CuCl, CuBr, CuI, and the like), a silver halide (e.g., AgF, AgCl, AgBr, AgI, and the like), a gold halide (e.g., AuF, AuCl, AuBr, AuI, and the like), and the like.

Examples of the post-transition metal halide may include a zinc halide (e.g., ZnF₂, ZnCl₂, ZnBr₂, ZnI₂, and the like), an indium halide (e.g., InI₃ and the like), a tin halide (e.g., SnI2 and the like), and the like. Examples of the lanthanide metal halide may include YbF, YbF₂, YbF₃, SmF₃, YbCl, YbCl₂, YbCl₃, SmCl₃, YbBr, YbBr₂, YbBr₃, SmBr₃, YbI, YbI₂, YbI₃, SmI₃, and the like. Examples of the metalloid halide may include an antimony halide (e.g., SbCl₅ and the like) and the like.

Examples of the metal telluride may include an alkali metal telluride (e.g., Li₂Te, Na₂Te, K₂Te, Rb₂Te, Cs₂Te, and the like), an alkaline earth metal telluride (e.g., BeTe, MgTe, CaTe, SrTe, BaTe, and the like), a transition metal telluride (e.g., TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, and the like), a post-transition metal telluride (e.g., ZnTe and the like), a lanthanide metal telluride (e.g., LaTe, CeTe, PrTe, NdTe, PmTe, EuTe, GdTe, TbTe, DyTe, HoTe, ErTe, TmTe, YbTe, LuTe, and the like), and the like.

### Emission layer in interlayer 130

When the light-emitting device 10 is a full color light-emitting device, the emission layer may be patterned into a red emission layer, a green emission layer, and/or a blue emission layer, according to sub-pixel. At least one of the emission layers may include the quantum dot described above. For example, the green emission layer may be a quantum dot emission layer including the quantum dot, and the blue emission layer and the red emission layer may each be an organic emission layer each including an organic compound.

In some embodiments, the emission layer may have a structure in which at least two of a red emission layer, a green emission layer, and a blue emission layer may contact each other or may be separated from each other. At least one emission layer of the at least two emission layers may be a quantum dot emission layer including the quantum dots, and the other emission layer may be an organic emission layer including organic compounds. Such a variation may be made.

### Electron transport region in interlayer 130

The electron transport region may have i) a single-layered structure consisting of a single layer consisting of a single material, ii) a single-layered structure consisting of a single layer including a plurality of different materials, or iii) a multi-layered structure having a plurality of layers including a plurality of different materials. Also, the electron transport region may further include a metal oxide layer in addition to the materials described above.

The electron transport region may include, for example, ZnO, TiO₂, WO₃, SnO₂, In₂O₃, Nb₂O₅, Fe₂O₃, CeO₂, SrTiO₃, Zn₂SnO₄, BaSnO₃, In₂S₃, ZnSiO, fullerene derivatives ([6,6]-phenyl-C60-butyric acid methyl ester PC60BM or [6,6]-phenyl-C70-butyric acid methyl ester PC70BM), ZnMgO, AZO, GZO, IZO, Al-doped TiO₂, Ga-doped TiO₂, In-doped TiO₂, Al-doped WO₃, Ga-doped WO₃, In-doped WO₃, Al-doped SnO₂, Ga-doped SnO₂, In-doped SnO₂, Mg-doped In₂O₃, Al-doped In₂O₃, Ga-doped In₂O₃, Mg-doped Nb₂O₅, Al-doped Nb₂O₅, Ga-doped Nb₂O₅, Mg-doped Fe₂O₃, Al-doped Fe₂O₃, Ga-doped Fe₂O₃, In-doped Fe₂O₃, Mg-doped CeO₂, Al-doped CeO₂, Ga-doped CeO₂, In-doped CeO₂, Mg-doped SrTiO₃, Al-doped SrTiO₃, Ga-doped SrTiO₃, In-doped SrTiO₃, Mg-doped Zn₂SnO₄, Al-doped Zn₂SnO₄, Ga-doped Zn₂SnO₄, In-doped Zn₂SnO₄, Mg-doped BaSnO₃, Al-doped BaSnO₃, Ga-doped BaSnO₃, In-doped BaSnO₃, Mg-doped In₂S₃, Al-doped In₂S₃, Ga-doped In₂S₃, In-doped In₂S₃, Mg-doped ZnSiO, Al-doped ZnSiO, Ga-doped ZnSiO, In-doped ZnSiO, or any combination thereof.

The electron transport region may include a buffer layer, a hole blocking layer, an electron control layer, an electron transport layer, or an electron injection layer. The buffer layer, the hole blocking layer, the electron control layer, the electron transport layer, or the electron injection layer may each be the metal oxide layer, or any combination of at least one layer of the buffer layer, the hole blocking layer, the electron control layer, and the electron transport layer may be the metal oxide layer.

In some embodiments, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein layers of each structure are sequentially stacked on the emission layer in each stated order.

The electron transport region (for example, the buffer layer, the hole blocking layer, the electron control layer, or the electron transport layer in the electron transport region) may include the metal oxide described above. The electron transport region (for example, the buffer layer, the hole blocking layer, the electron control layer, or the electron transport layer in the electron transport region) may include an organic material. For example, the electron transport region may include a metal-free compound including at least one π electron-depleted nitrogen-containing C₁-C₆₀ (*e.g.* C₁-C₃₀) cyclic group.

In some embodiments, the electron transport region may include a compound represented by Formula 601:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ (*e*.*g*. C₃-C₃₀) carbocyclic group unsubstituted or substituted with at least one R₁₀ₐ or a C₁-C₆₀ *(e.g.* C₁-C₂₀) heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ (*e*.*g*. C₃-C₃₀) carbocyclic group unsubstituted or substituted with at least one R₁₀ₐ, a C₁-C₆₀ *(e.g.* C₁-C₂₀) heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be understood by referring to the description of Q₁ provided herein,
xe21 may be 1, 2, 3, 4, or 5, and
at least one of Ar₆₀₁, L₆₀₁, and R₆₀₁ may each independently be a π electron-deficient nitrogen-containing C₁-C₆₀ (*e.g.* C₁-C₃₀) cyclic group unsubstituted or substituted with at least one R₁₀ₐ.

In some embodiments, when xe11 in Formula 601 is 2 or greater, at least two Ar₆₀₁(s) may be bound via a single bond. In some embodiments, in Formula 601, Ar₆₀₁ may be a substituted or unsubstituted anthracene group.

In some embodiments, the electron transport region may include a compound represented by Formula 601-1: 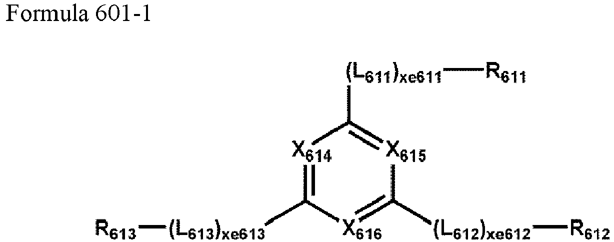 wherein, in Formula 601-1,
X₆₁₄ may be N or C(R₆₁₄), X₆₁₅ may be N or C(R₆₁₅), X₆₁₆ may be N or C(R₆₁₆), at least one selected from X₆₁₄ to X₆₁₆ may be N,
L₆₁₁ to L₆₁₃ may each be understood by referring to the description of L₆₀₁ provided herein,
xe611 to xe613 may each be understood by referring to the description of xel provided herein,
R₆₁₁ to R₆₁₃ may each be understood by referring to the description of R₆₀₁ provided herein, and
R₆₁₄ to R₆₁₆ may each independently be hydrogen, deuterium, -F, -Cl, -Br, -I, a hydroxyl group, a cyano group, a nitro group, a C₁-C₂₀ *(e.g.* C₁-C₁₀) alkyl group, a C₁-C₂₀ *(e.g.* C₁-C₁₀) alkoxy group, a C₃-C₆₀ *(e.g.* C₃-C₃₀) carbocyclic group unsubstituted or substituted with at least one R₁₀ₐ, or a C₁-C₆₀ *(e.g.* C₁-C₂₀) heterocyclic group unsubstituted or substituted with at least one R₁₀ₐ. For example, in Formulae 601 and 601-1, xe1 and xe611 to xe613 may each independently be 0, 1, or 2.

The electron transport region may include one of Compounds ET1 to ET45, 2,9-dimethyl-4,7-diphenyl-1,10-phenanthroline (BCP), 4,7-diphenyl-1,10-phenanthroline (Bphen), tris-(8-hydroxyquinoline)aluminium (Alq₃), bis(2-methyl-8-quinolinolato-N1,O8)-(1,1'-biphenyl-4-olato)aluminium (BAlq), 3-(biphenyl-4-yl)-5-(4-tert-butylphenyl)-4-phenyl-4H-1,2,4-triazole (TAZ), 4-(naphthalen-1-yl)-3,5-diphenyl-4H-1,2,4-triazole (NTAZ), or any combination thereof:

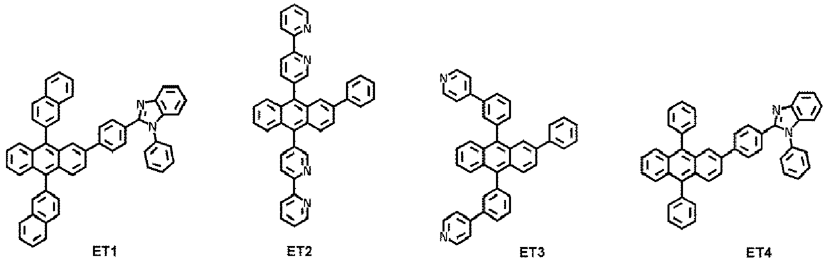

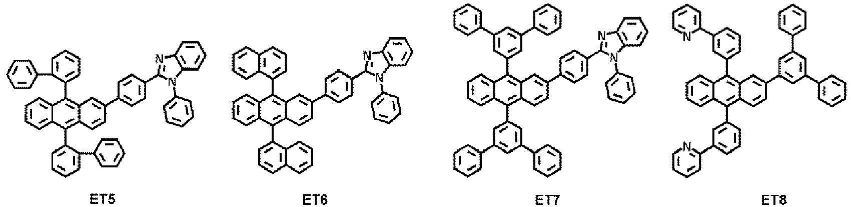

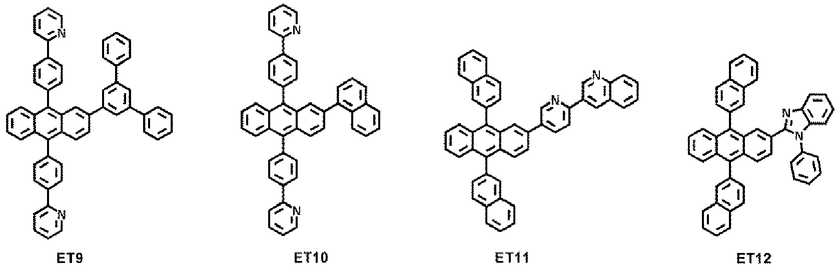

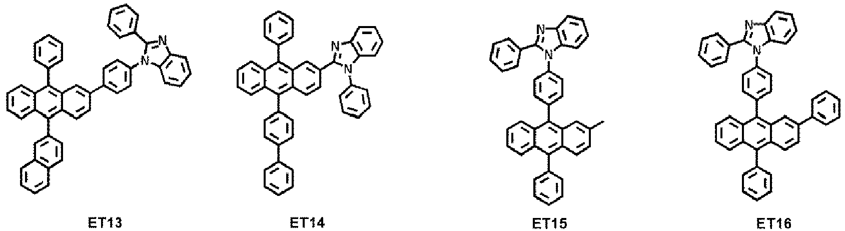

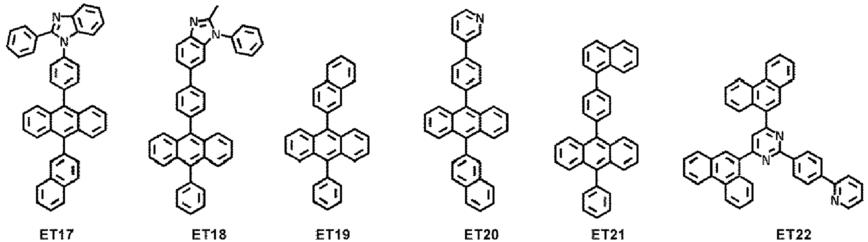

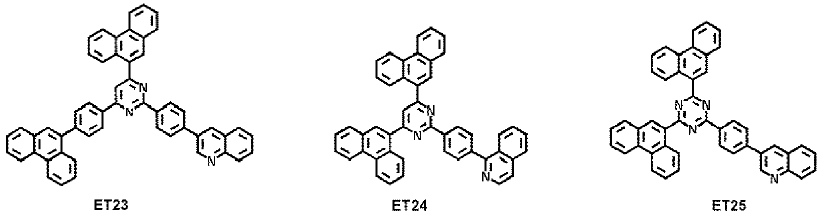

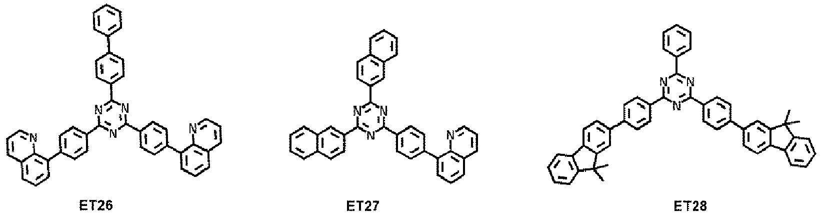

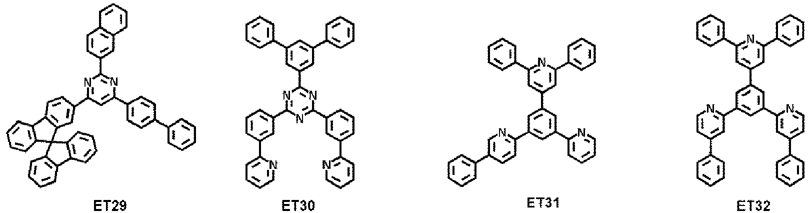

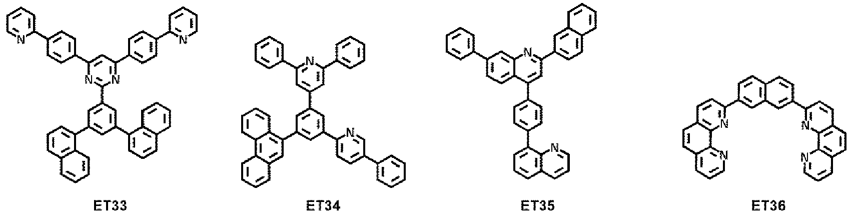

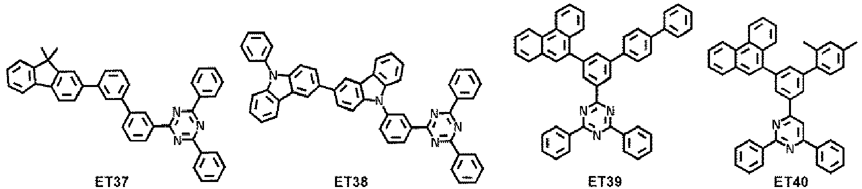

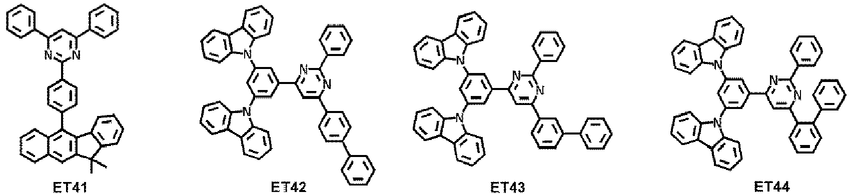

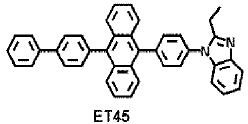

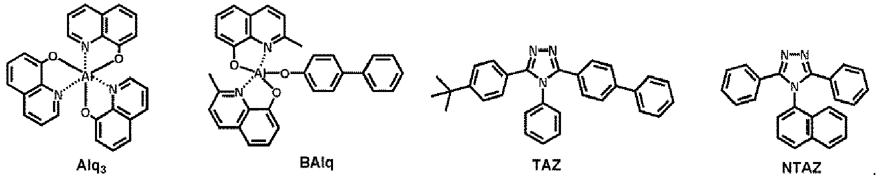

The thickness of the electron transport region may be in a range of about 100 Angstroms (Å) to about 5,000 Å, for example, about 160 Å to about 4,000 Å. When the electron transport region includes the buffer layer, the hole blocking layer, the electron control layer, the electron transport layer, or any combination thereof, the thicknesses of the buffer layer, the hole blocking layer, or the electron control layer may each independently be in a range of about 20 Å to about 1,000 Å, for example, about 30 Å to about 300 Å, and the thickness of the electron transport layer may be in a range of about 100 Å to about 1,000 Å, for example, about 150 Å to about 500 Å. When the thicknesses of the buffer layer, the hole blocking layer, the electron control layer, the electron transport layer, and/or the electron transport layer are each within these ranges, excellent electron transport characteristics may be obtained without a substantial increase in driving voltage.

The electron transport region (for example, the electron transport layer in the electron transport region) may further include, in addition to the materials described above, a metal-containing material. The metal-containing material may include an alkali metal complex, an alkaline earth metal complex, or any combination thereof. A metal ion of the alkali metal complex may be a lithium (Li) ion, a sodium (Na) ion, a potassium (K) ion, a rubidium (Rb) ion, or a cesium (Cs) ion. A metal ion of the alkaline earth metal complex may be a beryllium (Be) ion, a magnesium (Mg) ion, a calcium (Ca) ion, a strontium (Sr) ion, or a barium (Ba) ion. Each ligand coordinated with the metal ion of the alkali metal complex and the alkaline earth metal complex may independently be a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, the metal-containing material may include a Li complex. The Li complex may include, e.g., Compound ET-D1 (lithium quinolate, LiQ) or Compound ET-D2:

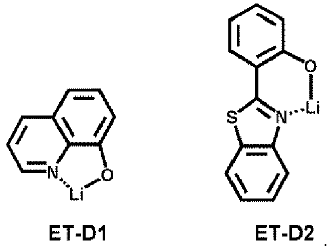

The electron transport region may include an electron injection layer that facilitates injection of electrons from the second electrode 150. The electron injection layer may be in direct contact with the second electrode 150. The electron injection layer may have i) a single-layered structure consisting of a single layer consisting of a single material, ii) a single-layered structure consisting of a single layer including a plurality of different materials, or iii) a multi-layered structure having a plurality of layers including a plurality of different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof The alkali metal may be Li, Na, K, Rb, Cs or any combination thereof. The alkaline earth metal may be Mg, Ca, Sr, Ba, or any combination thereof. The rare earth metal may be Sc, Y, Ce, Tb, Yb, Gd, or any combination thereof. The alkali metal-containing compound, the alkaline earth metal-containing compound, and the rare earth metal-containing compound may respectively be oxides, halides (e.g., fluorides, chlorides, bromides, or iodides), tellurides, or any combination thereof of each of the alkali metal, the alkaline earth metal, and the rare earth metal.

The alkali metal-containing compound may be alkali metal oxides such as Li₂O, Cs₂O, or K₂O, alkali metal halides such as LiF, NaF, CsF, KF, LiI, NaI, CsI, or KI, or any combination thereof. The alkaline earth-metal-containing compound may include alkaline earth-metal oxides, such as BaO, SrO, CaO, BaₓSr₁₋ₓO (wherein x is a real number satisfying 0<x<1), or BaₓCa₁₋ₓO (wherein x is a real number satisfying 0<x<1). The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In some embodiments, the rare earth metal-containing compound may include a lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and the like.

The alkali metal complex, the alkaline earth metal complex, and the rare earth metal complex may include: i) one of ions of the alkali metal, alkaline earth metal, and rare earth metal described above and ii) a ligand bond to the metal ion, e.g., a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

The electron injection layer may consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In some embodiments, the electron injection layer may further include an organic material (e.g., a compound represented by Formula 601).

In some embodiments, the electron injection layer may consist of i) an alkali metal-containing compound (e.g., alkali metal halide), or ii) a) an alkali metal-containing compound (e.g., alkali metal halide); and b) an alkali metal, an alkaline earth metal, a rare earth metal, or any combination thereof. In some embodiments, the electron injection layer may be a KI:Yb co-deposition layer, a RbI:Yb co-deposition layer, and the like. When the electron injection layer further includes an organic material, the alkali metal, the alkaline earth metal, the rare earth metal, the alkali metal-containing compound, the alkaline earth metal-containing compound, the rare earth metal-containing compound, the alkali metal complex, the alkaline earth metal complex, the rare earth metal complex, or any combination thereof may be homogeneously or non-homogeneously dispersed in a matrix including the organic material.

The thickness of the electron injection layer may be in a range of about 1 Å to about 100 Å, and in some embodiments, about 3 Å to about 90 Å. When the thickness of the electron injection layer is within any of these ranges, excellent electron injection characteristics may be obtained without a substantial increase in driving voltage.

### Second electrode 150

The second electrode 150 may be on the interlayer 130. In an embodiment, the second electrode 150 may be a cathode that is an electron injection electrode. In this embodiment, a material for forming the second electrode 150 may be a material having a low work function, for example, a metal, an alloy, an electrically conductive compound, or any combination thereof.

The second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), an ITO, an IZO, or any combination thereof. The second electrode 150 may be a transmissive electrode, a semi-transmissive electrode, or a reflective electrode. The second electrode 150 may have a single-layered structure, or a multi-layered structure including two or more layers.

### Capping layer

A first capping layer may be located outside the first electrode 110, and/or a second capping layer may be located outside the second electrode 150. In some embodiments, the light-emitting device 10 may have a structure in which the first capping layer, the first electrode 110, the interlayer 130, and the second electrode 150 are sequentially stacked in this stated order, a structure in which the first electrode 110, the interlayer 130, the second electrode 150, and the second capping layer are sequentially stacked in this stated order, or a structure in which the first capping layer, the first electrode 110, the interlayer 130, the second electrode 150, and the second capping layer are sequentially stacked in this stated order.

In the light-emitting device 10, light emitted from the emission layer in the interlayer 130 may pass through the first electrode 110 (which may be a semi-transmissive electrode or a transmissive electrode) and through the first capping layer to the outside. In the light-emitting device 10, light emitted from the emission layer in the interlayer 130 may pass through the second electrode 150 (which may be a semi-transmissive electrode or a transmissive electrode) and through the second capping layer to the outside.

Although not wanting to be bound by theory, the first capping layer and the second capping layer may improve the external luminescence efficiency based on the principle of constructive interference. Accordingly, the optical extraction efficiency of the light-emitting device 10 may be increased, thus improving the luminescence efficiency of the light-emitting device 10. The first capping layer and the second capping layer may each include a material having a refractive index of about 1.6 or higher (at 589 nm).

The first capping layer and the second capping layer may each independently be a capping layer including an organic material, an inorganic capping layer including an inorganic material, or an organic-inorganic composite capping layer including an organic material and an inorganic material.

At least one of the first capping layer and the second capping layer may each independently include carbocyclic compounds, heterocyclic compounds, amine group-containing compounds, porphine derivatives, phthalocyanine derivatives, naphthalocyanine derivatives, alkali metal complexes, alkaline earth metal complexes, or any combination thereof The carbocyclic compound, the heterocyclic compound, and the amine group-containing compound may optionally be substituted with a substituent of O, N, S, Se, Si, F, Cl, Br, I, or any combination thereof. In some embodiments, at least one of the first capping layer and the second capping layer may each independently include an amine group-containing compound.

In some embodiments, at least one of the first capping layer and the second capping layer may each independently include the compound represented by Formula 201, the compound represented by Formula 202, or any combination thereof.

In one or more embodiments, at least one of the first capping layer and the second capping layer may each independently include one of Compounds HT28 to HT33, one of Compounds CP1 to CP6, N4,N4'-di(naphthalen-2-yl)-N4,N4'-diphenyl-[1,1'-biphenyl]-4,4'-diamine (β-NPB), or any combination thereof:

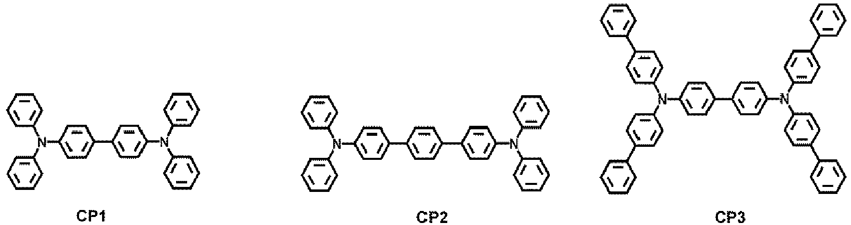

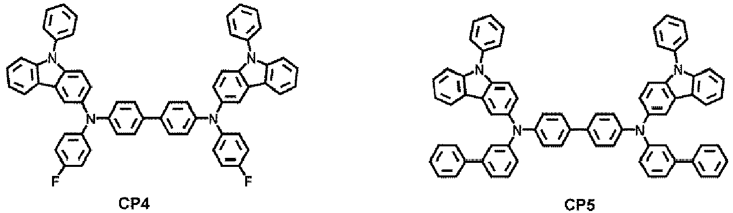

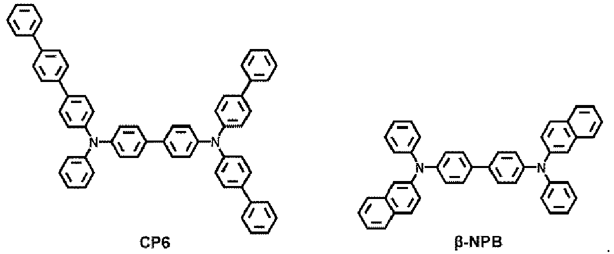

### Electronic apparatus

The light-emitting device 10 may be included in various electronic apparatuses. In some embodiments, an electronic apparatus including the light-emitting device 10 may be an emission apparatus or an authentication apparatus.

The electronic apparatus (e.g., an emission apparatus) may further include, in addition to the light-emitting device 10, i) a color filter, ii) a color-conversion layer, or iii) a color filter and a color-conversion layer. The color filter and/or the color-conversion layer may be disposed on at least one traveling direction of light emitted from the light-emitting device 10. For example, light emitted from the light-emitting device 10 may be blue light or white light. The light-emitting device 10 may be understood by referring to the descriptions provided herein. In some embodiments, the color-conversion layer may include quantum dots. The quantum dot may be, for example, the quantum dot described herein.

The electronic apparatus may include a first substrate. The first substrate may include a plurality of sub-pixel areas, the color filter may include a plurality of color filter areas respectively corresponding to the plurality of sub-pixel areas, and the color-conversion layer may include a plurality of color-conversion areas respectively corresponding to the plurality of sub-pixel areas.

A pixel-defining film may be located between the plurality of sub-pixel areas to define each sub-pixel area. The color filter may further include a plurality of color filter areas and light-blocking patterns between the plurality of color filter areas, and the color-conversion layer may further include a plurality of color-conversion areas and light-blocking patterns between the plurality of color-conversion areas.

The plurality of color filter areas (or a plurality of color-conversion areas) may include: a first area emitting first color light; a second area emitting second color light; and/or a third area emitting third color light, and the first color light, the second color light, and/or the third color light may have different maximum emission wavelengths. In some embodiments, the first color light may be red light, the second color light may be green light, and the third color light may be blue light. In some embodiments, the plurality of color filter areas (or the plurality of color-conversion areas) may each include quantum dots. In some embodiments, the first area may include red quantum dots, the second area may include green quantum dots, and the third area may not include a quantum dot. The quantum dot may be understood by referring to the description of the quantum dot provided herein. The first area, the second area, and/or the third area may each further include an emitter.

In some embodiments, the light-emitting device 10 may emit first light, the first area may absorb the first light to emit 1-1 color light, the second area may absorb the first light to emit 2-1 color light, and the third area may absorb the first light to emit 3-1 color light. In this embodiment, the 1-1 color light, the 2-1 color light, and the 3-1 color light may each have a different maximum emission wavelength. In some embodiments, the first light may be blue light, the 1-1 color light may be red light, the 2-1 color light may be green light, and the 3-1 light may be blue light.

The electronic apparatus may further include a thin-film transistor, in addition to the light-emitting device 10. The thin-film transistor may include a source electrode, a drain electrode, and an active layer, wherein one of the source electrode and the drain electrode may be electrically connected to one of the first electrode and the second electrode of the light-emitting device 10. The thin-film transistor may further include a gate electrode, a gate insulating film, or the like. The active layer may include a crystalline silicon, an amorphous silicon, an organic semiconductor, and an oxide semiconductor.

The electronic apparatus may further include an encapsulation unit for sealing the light-emitting device 10. The encapsulation unit may be located between the color filter and/or the color-conversion layer and the light-emitting device 10. The encapsulation unit may allow light to pass to the outside from the light-emitting device 10 and prevent the air and moisture to permeate to the light-emitting device 10 at the same time. The encapsulation unit may be a sealing substrate including transparent glass or a plastic substrate. The encapsulation unit may be a thin-film encapsulating layer including at least one of an organic layer and/or an inorganic layer. When the encapsulation unit is a thin-film encapsulating layer, the electronic apparatus may be flexible.

In addition to the color filter and/or the color-conversion layer, various functional layers may be disposed on the encapsulation unit depending on the use of an electronic apparatus. Examples of the functional layer may include a touch screen layer, a polarization layer, or the like. The touch screen layer may be a resistive touch screen layer, a capacitive touch screen layer, or an infrared beam touch screen layer. The authentication apparatus may be, for example, a biometric authentication apparatus that identifies an individual according to biometric information (e.g., a fingertip, a pupil, or the like). The authentication apparatus may further include a biometric information collecting unit, in addition to the light-emitting device 10 described above.

The electronic apparatus take the form of or may be applicable to various displays, an optical source, lighting, a personal computer (e.g., a mobile personal computer), a cellphone, a digital camera, an electronic note, an electronic dictionary, an electronic game console, a medical device (e.g., an electronic thermometer, a blood pressure meter, a glucometer, a pulse measuring device, a pulse wave measuring device, an electrocardiograph recorder, an ultrasonic diagnosis device, or an endoscope display device), a fish finder, various measurement devices, gauges (e.g., gauges of an automobile, an airplane, or a ship), and a projector.

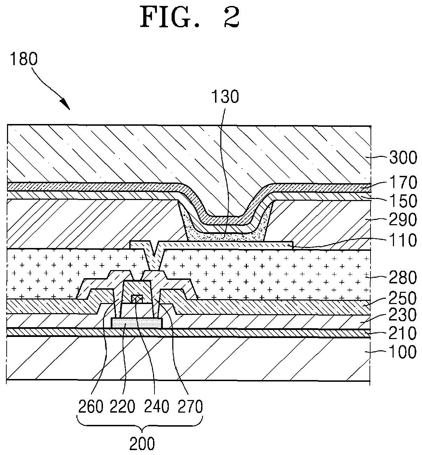

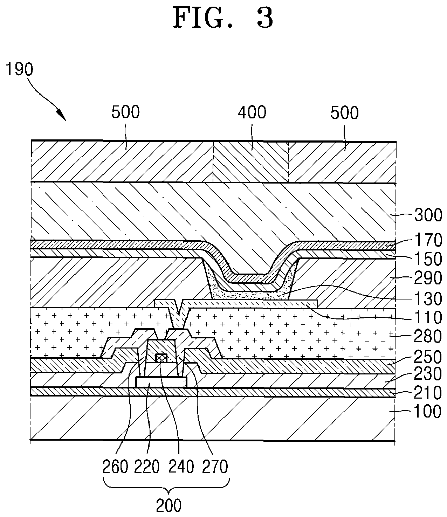

### Descriptions of FIGS. 2 and 3

FIG. 2 is a schematic cross-sectional view of an embodiment of a light-emitting apparatus including a light-emitting device constructed according to the principles of the invention.

An emission apparatus 180 in FIG. 2 may include a substrate 100, a thin-film transistor 200, a light-emitting device 10, and an encapsulation unit 300 sealing the light-emitting device 10.

The substrate 100 may be a flexible substrate, a glass substrate, or a metal substrate. A buffer layer 210 may be on the substrate 100. The buffer layer 210 may prevent penetration of impurities through the substrate 100 and provide a substantially flat surface on the substrate 100.

The thin-film transistor 200 may be on the buffer layer 210. The thin-film transistor 200 may include an active layer 220, a gate electrode 240, a source electrode 260, and a drain electrode 270.

The active layer 220 may include an inorganic semiconductor such as silicon or polysilicon, an organic semiconductor, or an oxide semiconductor and include a source area, a drain area, and a channel area. A gate insulating film 230 for insulating the active layer 220 and the gate electrode 240 may be on the active layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270 to provide insulation therebetween. The source electrode 260 and the drain electrode 270 may be on the interlayer insulating film 250. The interlayer insulating film 250 and the gate insulating film 230 may be formed to expose the source area and the drain area of the active layer 220, and the source electrode 260 and the drain electrode 270 may be adjacent to the exposed source area and the exposed drain area of the active layer 220.

Such a thin-film transistor 200 may be electrically connected to a light-emitting device 10 to drive the light-emitting device 10 and may be protected by a passivation layer 280. The passivation layer 280 may include an inorganic insulating film, an organic insulating film, or a combination thereof. The light-emitting device 10 may be on the passivation layer 280. The light-emitting device 10 may include a first electrode 110, an interlayer 130, and a second electrode 150.

The first electrode 110 may be on the passivation layer 280. The passivation layer 280 may not fully cover the drain electrode 270 and expose a specific area of the drain electrode 270, and the first electrode 110 may be disposed to connect to the exposed area of the drain electrode 270.

A pixel-defining film 290 may be on the first electrode 110. The pixel-defining film 290 may expose a specific area of the first electrode 110, and the interlayer 130 may be formed in the exposed area of the first electrode 110. The pixel-defining film 290 may be a polyimide or a polyacryl organic film. At least some higher layers of the interlayer 130 may extend to the upper portion of the pixel-defining film 290 and may be disposed in the form of a common layer. The second electrode 150 may be on the interlayer 130, and a capping layer 170 may be additionally formed on the second electrode 150. The capping layer 170 may be formed to cover the second electrode 150.

The encapsulation unit 300 may be on the capping layer 170. The encapsulation unit 300 may be on the light-emitting device 10 to protect a light-emitting device 10 from moisture or oxygen. The encapsulation unit 300 may include: an inorganic film including a silicon nitride (SiNₓ), a silicon oxide (SiOₓ), an indium tin oxide, an indium zinc oxide, or any combination thereof; an organic film including a polyethylene terephthalate, a polyethylene naphthalate, a polycarbonate, a polyimide, a polyethylene sulfonate, a polyoxymethylene, a polyarylate, a hexamethyl disiloxane, an acrylic resin (e.g., a polymethyl methacrylate, a polyacrylic acid, and the like), an epoxy resin (e.g., an aliphatic glycidyl ether (AGE) and the like), or any combination thereof; or a combination of the inorganic film and the organic film.

FIG. 3 is a schematic cross-sectional view of another embodiment of a light-emitting apparatus including a light-emitting device constructed according to the principles of the invention.

The emission apparatus 190 shown in FIG. 3 may be substantially identical to the emission apparatus 180 shown in FIG. 2, except that a light-shielding pattern 500 and a functional area 400 are additionally located on the encapsulation unit 300. The functional area 400 may be i) a color filter area, ii) a color-conversion area, or iii) a combination of a color filter area and a color-conversion area. In some embodiments, the light-emitting device 10 shown in FIG. 3 included in the emission apparatus 190 may be a tandem light-emitting device.

### Manufacturing method

The layers constituting the hole transport region, the emission layer, and the layers constituting the electron transport region may be formed in a specific region by using one or more suitable methods such as vacuum deposition, spin-coating, casting, Langmuir-Blodgett (LB) deposition, ink-jet printing, laser printing, and laser-induced thermal imaging.

When layers constituting the hole transport region, an emission layer, and layers constituting the electron transport region are each independently formed by vacuum-deposition, the vacuum-deposition may be performed at a deposition temperature in a range of about 100 °C to about 500 °C, at a vacuum degree in a range of about 10⁻⁸ torr to about 10⁻³ torr, and at a deposition rate in a range of about 0.01 Angstroms per second (Å/sec) to about 100 Å/sec, depending on the material to be included in each layer and the structure of each layer to be formed.

### General definitions of terms

As used herein, the term "energy level" may be expressed in "electron volt" and abbreviated as "eV".

As used herein, the term "atom" may mean an element or its corresponding radical bonded to one or more other atoms.

The terms "hydrogen" and "deuterium" refer to their respective atoms and corresponding radicals with the deuterium radical abbreviated "-D", and the terms "-F, -Cl, -Br, and -I" are radicals of, respectively, fluorine, chlorine, bromine, and iodine.

As used herein, a substituent for a monovalent group, e.g., alkyl, may also be, independently, a substituent for a corresponding divalent group, e.g., alkylene.

The term "Group II" as used herein may include Group IIA elements and Group IIB elements in the IUPAC Periodic Table of Elements. Examples of the Group II element may include Cd, Mg, and Zn, but embodiments are not limited thereto.

The term "Group III" as used herein may include Group IIIA elements and Group IIIB elements in the IUPAC Periodic Table of Elements. Examples of the Group III element may include Al, In, Ga, and Tl, but embodiments are not limited thereto.

The term "Group IV" as used herein may include Group IVA elements and Group IVB elements in the IUPAC Periodic Table of Elements. Examples of the Group IV element may include Si, Ge, and Sn, but embodiments are not limited thereto.

The term "Group V" as used herein may include Group VA elements in the IUPAC Periodic Table of Elements. Examples of the Group V element may include N, P, As, Sb, and Bi, but embodiments are not limited thereto.

The term "Group VI" as used herein may include VIA group elements in the IUPAC Periodic Table of Elements. Examples of the Group VI element may include O, S, Se, and Te, but embodiments are not limited thereto.

The term "metal" as used herein may include metalloid such as Si. Examples of the metalloid may include B, Si, Ge, As, Sb, Te, and the like.

The term "quantum dot" as used herein refers to a crystal of a semiconductor compound and may include any suitable material capable of emitting emission wavelengths of various lengths according to the size of the crystal.

The term "C₃-C₆₀ carbocyclic group" as used herein refers to a cyclic group consisting of carbon atoms only and having 3 to 60 carbon atoms as ring-forming atoms. The term "C₁-C₆₀ heterocyclic group" as used herein refers to a cyclic group having 1 to 60 carbon atoms in addition to a heteroatom as ring-forming atoms other than carbon atoms. The C₃-C₆₀ carbocyclic group and the C₁-C₆₀ heterocyclic group may each be a monocyclic group consisting of one ring or a polycyclic group in which at least two rings are fused. For example, the number of ring-forming atoms in the C₁-C₆₀ heterocyclic group may be in a range of 3 to 61.

The term "cyclic group" as used herein may include the C₃-C₆₀ carbocyclic group and the C₁-C₆₀ heterocyclic group.

The term "π electron-rich C₃-C₆₀ cyclic group" refers to a cyclic group having 3 to 60 carbon atoms and not including ^{∗}-N=^{∗}' as a ring-forming moiety. The term "π electron-deficient nitrogen-containing C₁-C₆₀ cyclic group" as used herein refers to a heterocyclic group having 1 to 60 carbon atoms and ^{∗}-N=^{∗}' as a ring-forming moiety.

In some embodiments, the C₃-C₆₀ carbocyclic group may be i) a group T1 or ii) a group in which at least two groups T1 are fused, for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group.

The C₁-C₆₀ heterocyclic group may be i) a group T2, ii) a group in which at least two groups T2 are fused, or iii) a group in which at least one group T2 is fused with at least one group T1, for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonapthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and the like.

The *π* electron-rich C₃-C₆₀ cyclic group may be i) a group T1, ii) a fused group in which at least two groups T1 are fused, iii) a group T3, iv) a fused group in which at least two groups T3 are fused, or v) a fused group in which at least one group T3 is fused with at least one group T1, for example, a C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonapthothiophene group, a benzonaphthosilole group, a benzofurodibenzofuran group, a benzofurodibenzothiophene group, a benzothienodibenzothiophene group, and the like.

The *π* electron-deficient nitrogen-containing C₁-C₆₀ cyclic group may be i) a group T4, ii) a group in which at least two groups T4 are fused, iii) a group in which at least one group T4 is fused with at least one group T1, iv) a group in which at least one group T4 is fused with at least one group T3, or v) a group in which at least one group T4, at least one group T1, and at least one group T3 are fused, for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and the like.

The group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo [2.2.1] heptane) group, a norbornene group, a bicyclo[1.1.1]pentane group, a bicyclo[2.1.1]hexane group, a bicyclo[2.2.2]octane group, or a benzene group,

The group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group.

The group T3 may be a furan group, a thiophene group, a 1H-pyrrole group, a silole group, or a borole group.

The group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The term "cyclic group", "C₃-C₆₀ carbocyclic group", "C₁-C₆₀ heterocyclic group", "π electron-rich C₃-C₆₀ cyclic group", or "π electron-deficient nitrogen-containing C₁-C₆₀ cyclic group" as used herein may be a group fused with any suitable cyclic group, a monovalent group, or a polyvalent group (e.g., a divalent group, a trivalent group, a quadvalent group, or the like), depending on the structure of the formula to which the term is applied. For example, a "benzene group" may be a benzene ring, a phenyl group, a phenylene group, or the like, and this may be understood by one of ordinary skill in the art, depending on the structure of the formula including the "benzene group".

Examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic fused polycyclic group, and a monovalent non-aromatic fused heteropolycyclic group. Examples of the divalent C₃-C₆₀ carbocyclic group and the divalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic fused polycyclic group, and a divalent non-aromatic fused heteropolycyclic group.

The "C₁-C₆₀ alkyl group" as used herein refers to a linear or branched aliphatic hydrocarbon monovalent group having 1 to 60 carbon atoms. Examples of the C₁-C₆₀ alkyl group include a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group. The term "C₁-C₆₀ alkylene group" as used herein refers to a divalent group having a structure corresponding to the C₁-C₆₀ alkyl group. Corresponding definitions apply to other ranges given for the number of carbon atoms in an alkyl/alkylene group.

The term "C₂-C₆₀ alkenyl group" as used herein refers to a hydrocarbon group having at least one carbon-carbon double bond in the middle or at the terminus of the C₂-C₆₀ alkyl group. Examples thereof include an ethenyl group, a propenyl group, and a butenyl group. The term "C₂-C₆₀ alkenylene group" as used herein refers to a divalent group having a structure corresponding to the C₂-C₆₀ alkenyl group. Corresponding definitions apply to other ranges given for the number of carbon atoms in an alkenyl/alkenylene group.

The term "C₂-C₆₀ alkynyl group" as used herein refers to a monovalent hydrocarbon group having at least one carbon-carbon triple bond in the middle or at the terminus of the C₂-C₆₀ alkyl group. Examples thereof include an ethynyl group and a propynyl group. The term "C₂-C₆₀ alkynylene group" as used herein refers to a divalent group having a structure corresponding to the C₂-C₆₀ alkynyl group. Corresponding definitions apply to other ranges given for the number of carbon atoms in an alkynyl/alkynylene group.

The term "C₁-C₆₀ alkoxy group" as used herein refers to a monovalent group represented by -OA₁₀₁ (wherein A₁₀₁ is a C₁-C₁ alkyl group). Examples thereof include a methoxy group, an ethoxy group, and an isopropyloxy group. Corresponding definitions apply to other ranges given for the number of carbon atoms in an alkoxy group.

The term "C₃-C₁₀ cycloalkyl group" as used herein refers to a monovalent saturated hydrocarbon monocyclic group including 3 to 10 carbon atoms. Examples of the C₃-C₁₀ cycloalkyl group as used herein include a cyclopropyl group, a cyclobutyl group, a cyclopentyl group, a cyclohexyl group, a cycloheptyl group, a cyclooctyl group, an adamantyl group, a norbornyl (bicyclo[2.2.1]heptyl) group, a bicyclo[1.1.1]pentyl group, a bicyclo[2.1.1]hexyl group, or a bicyclo[2.2.2]octyl group. The term "C₃-C₁₀ cycloalkylene group" as used herein refers to a divalent group having a structure corresponding to the C₃-C₁₀ cycloalkyl group.

The term "C₁-C₁₀ heterocycloalkyl group" as used herein refers to a monovalent cyclic group including at least one heteroatom other than carbon atoms as a ring-forming atom and having 1 to 10 carbon atoms. Examples thereof include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having a structure corresponding to the C₁-C₁₀ heterocycloalkyl group.

The term "C₃-C₁₀ cycloalkenyl group" as used herein refers to a monovalent cyclic group that has 3 to 10 carbon atoms and at least one carbon-carbon double bond in its ring, and is not aromatic. Examples thereof include a cyclopentenyl group, a cyclohexenyl group, and a cycloheptenyl group. The term "C₃-C₁₀ cycloalkenylene group" as used herein refers to a divalent group having a structure corresponding to the C₃-C₁₀ cycloalkenyl group.

The term "C₁-C₁₀ heterocycloalkenyl group" as used herein refers to a monovalent cyclic group including at least one heteroatom other than carbon atoms as a ring-forming atom, 1 to 10 carbon atoms, and at least one double bond in its ring. Examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkylene group" as used herein refers to a divalent group having a structure corresponding to the C₁-C₁₀ heterocycloalkyl group.

The term "C₆-C₆₀ aryl group" as used herein refers to a monovalent group having a carbocyclic aromatic system having 6 to 60 carbon atoms. The term "C₆-C₆₀ arylene group" as used herein refers to a divalent group having a carbocyclic aromatic system having 6 to 60 carbon atoms. Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each independently include two or more rings, the respective rings may be fused. Corresponding definitions apply to other ranges given for the number of carbon atoms in an aryl/arylene group.

The term "C₁-C₆₀ heteroaryl group" as used herein refers to a monovalent group having a heterocyclic aromatic system further including at least one heteroatom other than carbon atoms as a ring-forming atom and 1 to 60 carbon atoms. The term "C₁-C₆₀ heteroarylene group" as used herein refers to a divalent group having a heterocyclic aromatic system further including at least one heteroatom other than carbon atoms as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each independently include two or more rings, the respective rings may be fused. Corresponding definitions apply to other ranges given for the number of carbon atoms in an heteroaryl/heteroarylene group.

The term "monovalent non-aromatic fused polycyclic group" as used herein refers to a monovalent group having two or more rings fused and only carbon atoms (for example, having 8 to 60 carbon atoms) as ring-forming atoms, wherein the molecular structure as a whole is non-aromatic. Examples of the monovalent non-aromatic fused polycyclic group include an indenyl group, a fluorenyl group, a spiro-bifluorenyl group, a benzofluorenyl group, an indenophenanthrenyl group, and an indenoanthracenyl group. The term "divalent non-aromatic fused polycyclic group" as used herein refers to a divalent group having substantially a structure corresponding to the monovalent non-aromatic fused polycyclic group.

The term "monovalent non-aromatic fused heteropolycyclic group" as used herein refers to a monovalent group having two or more rings fused and carbon atoms (for example, having 1 to 60 carbon atoms) and at least one heteroatom as ring-forming atoms, wherein the molecular structure as a whole is non-aromatic. Examples of the monovalent non-aromatic fused heteropolycyclic group may include a 9,9-dihydroacridinyl group and a 9H-xanthenyl group. The term "divalent non-aromatic fused heteropolycyclic group" as used herein refers to a divalent group having substantially a structure corresponding to the monovalent non-aromatic fused heteropolycyclic group.

The term "C₆-C₆₀ aryloxy group" as used herein refers to -OA₁₀₂ (wherein A₁₀₂ is a C₆-C₆₀ aryl group), and a C₆-C₆₀ arylthio group as used herein refers to -SA₁₀₃ (wherein A₁₀₃ is a C₆-C₆₀ aryl group). Corresponding definitions apply to other ranges given for the number of carbon atoms in an aryloxy group and an arylthio group.

The term "C₇-C₆₀ aryl alkyl group" used herein refers to -A₁₀₄A₁₀₅ (where A₁₀₄ may be a C₁-C₅₄ alkylene group, and A₁₀₅ may be a C₆-C₅₉ aryl group), and the term "C₂-C₆₀ heteroaryl alkyl group" used herein refers to -A₁₀₆A₁₀₇ (where A₁₀₆ may be a C₁-C₅₉ alkylene group, and A₁₀₇ may be a C₁-C₅₉ heteroaryl group).

The term "R₁₀ₐ" as used herein may be:
deuterium (-D), -F, -Cl, -Br, -I, a hydroxyl group, a cyano group, or a nitro group;
a C₁-C₆₀ *(e.g.* C₁-C₂₀) alkyl group, a C₂-C₆₀ *(e.g.* C₂-C₂₀) alkenyl group, a C₂-C₆₀ *(e.g.* C₂-C₂₀) alkynyl group, or a C₁-C₆₀ *(e.g.* C₁-C₂₀) alkoxy group, each, independently from one another, unsubstituted or substituted with deuterium, -F, -Cl, -Br, -I, a hydroxyl group, a cyano group, a nitro group, a C₃-C₆₀ (*e.g.* C₃-C₃₀) carbocyclic group, a C₁-C₆₀ *(e.g.* C₁-C₂₀) heterocyclic group, a C₆-C₆₀ *(e.g.* C₆-C₃₀) aryloxy group, a C₆-C₆₀ *(e.g.* C₆-C₃₀) arylthio group, a C₇-C₆₀ (*e.g.* C₇-C₃₀) aryl alkyl group, a C₂-C₆₀ *(e.g.* C₂-C₂₀) heteroaryl alkyl group, - Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ (*e.g.* C₃-C₃₀) carbocyclic group, a C₁-C₆₀ *(e.g.* C₁-C₂₀) heterocyclic group, a C₆-C₆₀ *(e.g.* C₆-C₃₀) aryloxy group, a C₆-C₆₀ *(e.g.* C₆-C₃₀) arylthio group, a C₇-C₆₀ (*e.g.* C₇-C₃₀) aryl alkyl group, or a C₂-C₆₀ *(e.g.* C₂-C₂₀) heteroaryl alkyl group, each, independently from one another, unsubstituted or substituted with deuterium, -F, -Cl, -Br, -I, a hydroxyl group, a cyano group, a nitro group, a C₁-C₆₀ *(e.g.* C₁-C₂₀) alkyl group, a C₂-C₆₀ *(e.g.* C₂-C₂₀) alkenyl group, a C₂-C₆₀ *(e.g.* C₂-C₂₀) alkynyl group, a C₁-C₆₀ *(e.g.* C₁-C₂₀) alkoxy group, a C₃-C₆₀ (*e.g.* C₃-C₃₀) carbocyclic group, a C₁-C₆₀ *(e.g.* C₁-C₂₀) heterocyclic group, a C₆-C₆₀ *(e.g.* C₆-C₃₀) aryloxy group, a C₆-C₆₀ *(e.g.* C₆-C₃₀) arylthio group, a C₇-C₆₀ (*e.g.* C₇-C₃₀) aryl alkyl group, a C₂-C₆₀ *(e.g.* C₂-C₂₀) heteroaryl alkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or -P(=O)(Q₃₁)(Q₃₂).
Q₁ to Q₃, Q₁₁ to Q₁₃, Q₂₁ to Q₂₃ and Q₃₁ to Q₃₃ may each independently be: hydrogen; deuterium; -F; -Cl; -Br; -I; a hydroxyl group; a cyano group; a nitro group; a C₁-C₆₀ *(e.g.* C₁-C₂₀) alkyl group; a C₂-C₆₀ *(e.g.* C₂-C₂₀) alkenyl group; a C₂-C₆₀ *(e.g.* C₂-C₂₀) alkynyl group; a C₁-C₆₀ *(e.g.* C₁-C₂₀) alkoxy group; a C₃-C₆₀ (*e.g.* C₃-C₃₀) carbocyclic group or a C₁-C₆₀ *(e.g.* C₁-C₂₀) heterocyclic group, each unsubstituted or substituted with deuterium, -F, a cyano group, a C₁-C₆₀ *(e.g.* C₁-C₂₀) alkyl group, a C₁-C₆₀ *(e.g.* C₁-C₂₀) alkoxy group, a phenyl group, a biphenyl group, or any combination thereof; a C₇-C₆₀ (*e.g*. C₇-C₃₀) aryl alkyl group; or a C₂-C₆₀ *(e.g.* C₂-C₂₀) heteroaryl alkyl group.

The term "heteroatom" as used herein refers to any atom other than a carbon atom. Examples of the heteroatom may include O, S, N, P, Si, B, Ge, Se, or any combination thereof.

A third-row transition metal as used herein may include hafnium (Hf), tantalum (Ta), tungsten (W), rhenium (Re), osmium (Os), iridium (Ir), platinum (Pt), and gold (Au).

As used herein, "Ph" represents a phenyl group, "Me" represents a methyl group, "Et" represents an ethyl group, "ter-Bu", "t-butanol" or "Bu^{t}" represents a tert-butyl group or alcohol, and "OMe" represents a methoxy group. Moreover, "n-" represents normal, "neo" represents a hydrocarbon in which at least one carbon atom is connected directly to four other carbon atoms, such as neopentane and neohexene, "iso" represents an isomer of an alkyl hydrocarbon having a subordinate chain of one or more carbon atoms attached to a carbon of the straight chain, and "sec" represents a secondary structure.

The term "biphenyl group" as used herein refers to a phenyl group substituted with a phenyl group. The "biphenyl group" belongs to a substituted phenyl group having a C₆-C₆₀ aryl group as a substituent.

The term "terphenyl group" as used herein refers to a phenyl group substituted with a biphenyl group. The "terphenyl group" belongs to "a substituted phenyl group" having a "C₆-C₆₀ aryl group substituted with a C₆-C₆₀ aryl group" as a substituent.

The symbols ^{∗} and ^{∗}' as used herein, unless defined otherwise, refer to a binding site to an adjacent atom in a corresponding formula or moiety.

Hereinafter, a light-emitting device and the metal oxide compound according to one or more embodiments will be described in more detail with reference to Examples.

### Examples

### Preparation Example : Preparation of metal oxide composition

Metal oxide compositions were prepared according to the mixing ratio of compounds shown in Table 1.

**Table 1**

| Composition | Metal oxide | Solvent | Metal oxide content (solvent-based wt%) | Hydrogen cation source | Hydrogen cation source content (metal oxide-based wt%) |
|---|---|---|---|---|---|
| Composition 1 | ZnO | Ethanol | 5 wt% | - | - |
| Composition 2 | ZnO | Ethanol | 5 wt% | Compound 1 | 0.5 wt% |
| Composition 3 | ZnO | Ethanol | 5 wt% | Compound 1 | 2.5 wt% |
| Composition 4 | ZnO | Ethanol | 5 wt% | Compound 1 | 5.0 wt% |
| Composition 5 | ZnO | Ethanol | 5 wt% | Compound 2 | 2.5 wt% |
| Composition 6 | ZnO | Ethanol | 5 wt% | Compound 5 | 2.5 wt% |
| Composition 7 | ZnMgO | Ethanol | 5 wt% | - | - |
| Composition 8 | ZnMgO | Ethanol | 5 wt% | Compound 1 | 0.5 wt% |
| Composition 9 | ZnMgO | Ethanol | 5 wt% | Compound 1 | 2.5 wt% |
| Composition 10 | ZnMgO | Ethanol | 5 wt% | Compound 1 | 5.0 wt% |
| Composition 11 | ZnMgO | Ethanol | 5 wt% | Compound 2 | 2.5 wt% |
| Composition 12 | ZnMgO | Ethanol | 5 wt% | Compound 5 | 2.5 wt% |

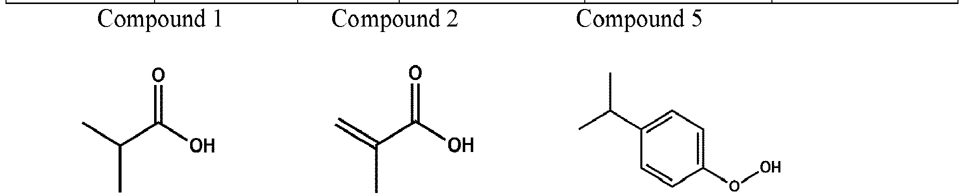

### Example 1

An ITO glass substrate (50 millimeters (mm) × 50mm and 15 Ohms per square centimeter (Ω/cm²)), an OLED glass (available from Samsung-Coming, Co. Ltd of Asan, Republic of Korea) substrate, was sequentially sonicated using distilled water and isopropyl alcohol, and cleaned by exposure to ultraviolet rays with ozone for about 30 minutes. Composition 2 was spin-coated on the ITO glass substrate to form a film to a thickness of 40 nm, followed by baking at a temperature of 100 °C for 30 minutes, thereby forming a metal oxide layer. An InP quantum dot composition (solvent: octane, solid concentration: InP 0.7 wt%) was spin-coated on the metal oxide layer to form a film to a thickness of 20 nm, followed by baking at a temperature of 120 °C for 10 minutes, thereby forming an emission layer. Composition 2 was spin-coated on the emission layer to form a film to a thickness of 40 nm, followed by baking at a temperature of 100 °C for 30 minutes, thereby forming a metal oxide layer. The element Al was deposited on the metal oxide layer to a thickness of 100 nm to form a cathode, thereby completing the manufacture of an electron only device (EOD). Then, heat-treating was further performed at a temperature of 75 °C for 24 hours. Deposition equipment sold under the trade designation SUICEL PLUS 200 by Sunic Systems Co., Ltd of Gyeonggi-do, Republic of Korea was used for the deposition.

Examples 2 to 18 and Comparative Examples 1 to 4 EODs were manufactured in the same manner as in Example 1, except that the metal oxide composition and/or time for 75 °C heat-treating were changed as shown in Table 2.

**Table 2**

| | Metal oxide composition | 75 °C heat-treating (hours) |
|---|---|---|
| Example 1 | Composition 2 | 24 |
| Example 2 | Composition 3 | 24 |
| Example 3 | Composition 3 | 0 |
| Example 4 | Composition 3 | 12 |
| Example 5 | Composition 3 | 48 |
| Example 6 | Composition 3 | 72 |
| Example 7 | Composition 4 | 24 |
| Example 8 | Composition 5 | 24 |
| Example 9 | Composition 6 | 24 |
| Example 10 | Composition 8 | 24 |
| Example 11 | Composition 9 | 24 |
| Example 12 | Composition 9 | 0 |
| Example 13 | Composition 9 | 12 |
| Example 14 | Composition 9 | 48 |
| Example 15 | Composition 9 | 72 |
| Example 16 | Composition 10 | 24 |
| Example 17 | Composition 11 | 24 |
| Example 18 | Composition 12 | 24 |
| Comparative Example 1 | Composition 1 | 24 |
| Comparative Example 2 | Composition 1 | 0 |
| Comparative Example 3 | Composition 7 | 24 |
| Comparative Example 4 | Composition 7 | 0 |

### Evaluation Example 1

The driving voltage in volts (V) of each of EODs manufactured in Examples 1 to 18 and Comparative Examples 1 to 4 was measured at a current density of 10 milliamperes per square centimeter (mA/cm²) by using a current-voltmeter (sold under the trade designation Keithley MU 236, by Tektronix, Inc., of Beaverton, Oregon). The results thereof are shown in Table 3.

**Table 3**

| | Driving voltage (V) |
|---|---|
| Example 1 | 1.4 |
| Example 2 | 1.0 |
| Example 3 | 1.8 |
| Example 4 | 1.5 |
| Example 5 | 1.1 |
| Example 6 | 1.3 |
| Example 7 | 1.3 |
| Example 8 | 1.3 |
| Example 9 | 1.2 |
| Example 10 | 1.8 |
| Example 11 | 1.2 |
| Example 12 | 2.0 |
| Example 13 | 1.8 |
| Example 14 | 1.3 |
| Example 15 | 1.4 |
| Example 16 | 1.5 |
| Example 17 | 1.6 |
| Example 18 | 1.4 |
| Comparative Example 1 | 3.6 |
| Comparative Example 2 | 3.5 |
| Comparative Example 3 | 4.2 |
| Comparative Example 4 | 4.0 |

Table 3 shows that the EODs of Examples 1 to 18 have significantly and unexpectedly improved driving voltages, as compared with the EODs of Comparative Examples 1 to 4. While not wishing to be bound by theory, the EODs of Comparative Examples 1 to 4 did not include a hydrogen cation source, and thus, oxygen vacancy on the surface of the metal oxide may serve as an electron-trapping site to increase the driving voltage. As apparent from the foregoing description, the metal oxide composition made according to the principles and one or more embodiments of the invention may reduce oxygen vacancy on the surface of the metal oxide, and accordingly, a light-emitting device manufactured from the metal oxide composition may have improved electron injection and transport efficiency, luminescence efficiency, and lifespan.

Although certain embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

1. A metal oxide composition comprising:
a solvent;
a metal oxide; and
a hydrogen cation source comprising a compound of Formula 1, a compound of Formula 2, or any combination thereof: 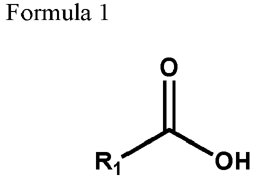 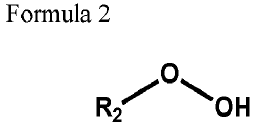 wherein, in Formulae 1 and 2,
R₁ and R₂ are each, independently from one another, hydrogen, deuterium, -F, -Cl, -Br, - I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂), and
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group each, independently from one another, unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group,-Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each, independently from one another, unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or -P(=O)(Q₃₁)(Q₃₂),
wherein Q₁ to Q₃, Q₁₁ to Q₁₃, Q₂₁ to Q₂₃, and Q₃₁ to Q₃₃ are each, independently from one another: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group; or a C₁-C₆₀ heterocyclic group each, independently from one another, unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ aryl alkyl group; or a C₂-C₆₀ heteroaryl alkyl group.

2. The metal oxide composition of claim 1, wherein R₁ and R₂ are each, independently from one another:
deuterium, -F, -Cl, -Br, -I, a hydroxyl group, a cyano group, or a nitro group;
a C₁-C₂₀ alkyl group or a C₂-C₂₀ alkenyl group each, independently from one another, unsubstituted or substituted with deuterium, -F, -Cl, -Br, -I, a hydroxyl group, a cyano group, a nitro group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, a triazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzoxazolyl group, a benzothiazolyl group, a dibenzofuranyl group, a dibenzothiophenyl group, a dibenzosilolyl group, a carbazolyl group, a benzocarbazolyl group, a dibenzocarbazolyl group, -Si(Q₁₁)(Q₁₂)(Q₁₃), -N(Q₁₁)(Q₁₂), -B(Q₁₁)(Q₁₂), or any combination thereof; or
a cyclopentyl group, a cyclohexyl group, a cycloheptyl group, a cyclopentenyl group, a cyclohexenyl group, a phenyl group, a biphenyl group, a terphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, a triazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzoxazolyl group, a benzothiazolyl group, a dibenzofuranyl group, a dibenzothiophenyl group, a dibenzosilolyl group, a carbazolyl group, a benzocarbazolyl group, or a dibenzocarbazolyl group each, independently from one another, unsubstituted or substituted with deuterium, -F, -Cl, -Br, -I, a hydroxyl group, a cyano group, a nitro group, a C₁-C₂₀ alkyl group, a C₂-C₂₀ alkenyl group, a cyclopentyl group, a cyclohexyl group, a cycloheptyl group, a cyclopentenyl group, a cyclohexenyl group, a phenyl group, a biphenyl group, a naphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, a triazinyl group, an indolyl group, an isoindolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzoxazolyl group, a benzothiazolyl group, a dibenzofuranyl group, a dibenzothiophenyl group, a dibenzosilolyl group, a carbazolyl group, a benzocarbazolyl group, a dibenzocarbazolyl group, -Si(Q₁₁)(Q₁₂)(Q₁₃), -N(Q₁₁)(Q₁₂), -B(Q₁₁)(Q₁₂), or any combination thereof,
wherein Q₁₁ to Q₁₃ have, independently from one another, the same meaning as in claim 1.

3. The metal oxide composition of claim 1, wherein R₁ and R₂ are each, independently from one another:
a methyl group, an ethyl group, a propyl group, an iso-propyl group, an n-butyl group, an isobutyl group, a sec-butyl group, a tert-butyl group, an n-pentyl group, an isopentyl group, a tert-pentyl group, a neo-pentyl group, a sec-pentyl group, a 3-pentyl group, a sec-isopentyl group, an n-hexyl group, an iso-hexyl group, a sec-hexyl group, a tert-hexyl group, a vinyl group, a 2-propenyl group, an isopropenyl group, a butenyl group, or a pentenyl group each, independently from one another, unsubstituted or substituted with deuterium, -F, -Cl, -Br, -I, a hydroxyl group, a cyano group, a nitro group, a cyclopentyl group, a cyclohexyl group, a cycloheptyl group, a cyclopentenyl group, a cyclohexenyl group, a phenyl group, a naphthyl group, or any combination thereof; or
a cyclopentyl group, a cyclohexyl group, a cycloheptyl group, a cyclopentenyl group, a cyclohexenyl group, a phenyl group, a biphenyl group, a terphenyl group, or a naphthyl group each, independently from one another, unsubstituted or substituted with deuterium, -F, -Cl, -Br, - I, a hydroxyl group, a cyano group, a nitro group, a methyl group, an ethyl group, a propyl group, an iso-propyl group, an n-butyl group, an isobutyl group, a sec-butyl group, a tert-butyl group, an n-pentyl group, an isopentyl group, a tert-pentyl group, a neo-pentyl group, a sec-pentyl group, a 3-pentyl group, a sec-isopentyl group, an n-hexyl group, an iso-hexyl group, a sec-hexyl group, a tert-hexyl group, a vinyl group, 2-prophenyl group, an isoprophenyl group, a butenyl group, a pentenyl group, a cyclopentyl group, a cyclohexyl group, a cycloheptyl group, a cyclopentenyl group, a cyclohexenyl group, a phenyl group, a naphthyl group, or any combination thereof.

4. The metal oxide composition of claim 1, wherein the hydrogen cation source is one of Compounds 1 to 7 or any combination thereof:

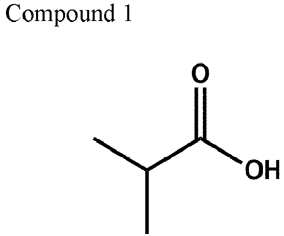

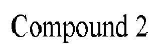

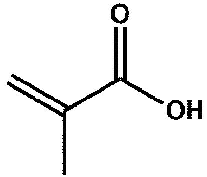

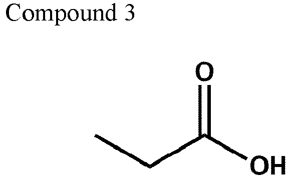

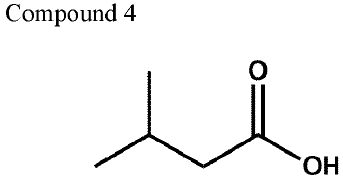

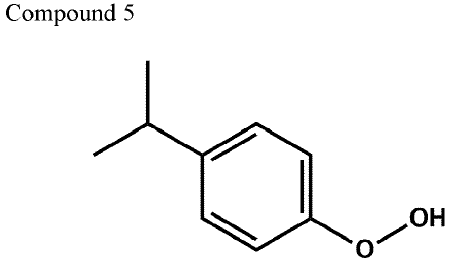

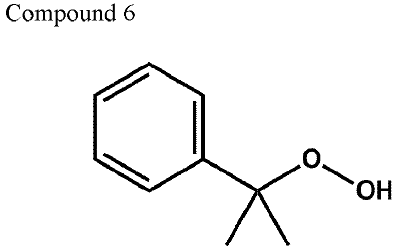

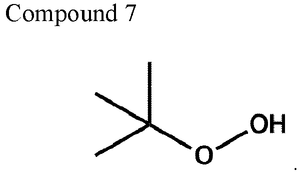

5. The metal oxide composition of any one of claims 1 to 4, wherein the metal oxide is of Formula 3:
Formula 3 MₓO_{y}
wherein, in Formula 3,
M is Zn, Ti, Zr, Sn, W, Ta, Ni, Mo, or Cu, and
x and y are each, independently from one another, an integer from 1 to 5.

6. The metal oxide composition of any one of claims 1 to 4, wherein the metal oxide is of Formula 4:
Formula 4 Zn_{1-z}(M₂)_{z}O_{y'}.
wherein, in Formula 4,
M₂ is a metal other than Zn,
0≤z≤0.5, and
0≤y'≤2.

7. The metal oxide composition of claim 6, wherein M₂ in Formula 4 is Mg, Co, Ni, Zr, Mn, Sn, Y, Al, Si, or Yb.

8. The metal oxide composition of any one of claims 1 to 7, wherein a content of the hydrogen cation source is in a range of about 0.01 wt% to about 30 wt%, based on a total weight of the metal oxide.

9. A method of manufacturing a light-emitting device, the method comprising:
forming, on a first electrode, an emission layer comprising quantum dots;
forming a metal oxide layer by providing, on the emission layer, the metal oxide composition of any one of claims 1 to 8; and
forming a second electrode on the metal oxide layer.

10. The method of claim 9, wherein:
(i) the forming of the emission layer comprises: providing, on the first electrode, a quantum dot composition comprising the quantum dots and a solvent; and removing the solvent; and/or
(ii) the forming of the metal oxide layer comprises: providing, on the emission layer, the metal oxide composition; and removing the solvent.

11. The method of claim 9 or claim 10, further comprising: after the forming of the second electrode, heat-treating the light-emitting device at a temperature in a range of about 50 °C to about 150 °C, optionally wherein the heat-treating is performed for about 10 hours to about 100 hours.

12. A light-emitting device comprising:
a first electrode;
a second electrode facing the first electrode;
an emission layer between the first electrode and the second electrode; and
a metal oxide layer between the emission layer and the second electrode,
wherein the emission layer comprises quantum dots, and
the metal oxide layer comprises: a metal oxide; and a hydrogen cation source comprising a compound of Formula 1, a compound of Formula 2, or any combination thereof: 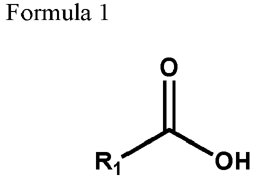 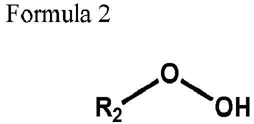 wherein, in Formulae 1 and 2,
R₁ and R₂ are each, independently from one another, hydrogen, deuterium, -F, -Cl, -Br, - I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -N(Q₁)(Q₂), -B(Q₁)(Q₂), -C(=O)(Q₁), -S(=O)₂(Q₁), or -P(=O)(Q₁)(Q₂), and
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group each, independently from one another, unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each, independently from one another, unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or -P(=O)(Q₃₁)(Q₃₂),
wherein Q₁ to Q₃, Q₁₁ to Q₁₃, Q₂₁ to Q₂₃, and Q₃₁ to Q₃₃ are each, independently from one another: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group; or a C₁-C₆₀ heterocyclic group each, independently from one another, unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ aryl alkyl group; or a C₂-C₆₀ heteroaryl alkyl group.

13. The light-emitting device of claim 12, wherein:
(i) the quantum dots in the emission layer comprise a semiconductor compound of Groups II-VI, a semiconductor compound of Groups III-V, a semiconductor compound of Groups III-VI, a semiconductor compound of Groups I, III, and VI, a semiconductor compound of Groups IV-VI, an element or a compound of Group IV, or any combination thereof; and/or
(ii) the quantum dots have a core-shell structure.

14. The light-emitting device of claims 12 or claim 13, wherein the first electrode comprises an anode,
the second electrode comprises a cathode,
the light-emitting device further comprises: a hole transport region between the first electrode and the emission layer; and an electron transport region between the emission layer and the second electrode, and
the electron transport region comprises the metal oxide layer, optionally wherein: the electron transport region comprises at least one layer of a buffer layer, a hole blocking layer, an electron control layer, an electron transport layer, and an electron injection layer, and
the metal oxide layer comprises the buffer layer, the hole blocking layer, the electron transport layer, or the electron injection layer.

15. The light-emitting device of any one of claims 12 to 14, wherein:
(i) the metal oxide of the metal oxide layer comprises a zinc-containing oxide; or
(ii) the metal oxide of the metal oxide layer comprises ZnO, ZnMgO, ZnAlO, ZnSiO, ZnYbO, TiO₂, WO₃, W₂O₃, WO₂, or any combination thereof.
